# EUROPEAN PATENT APPLICATION

(11) **EP 4 079 451 A1**
(43) Date of publication of application: **26.10.2022**
(21) Application number: 20903091.5
(22) Date of filing: 17.11.2020
(51) Int. Cl.: B24B 37/30, B24B 37/34, B24B 41/06, H01L 21/304, H01L 21/677

(54) **PUSHER, SUBSTRATE TRANSPORT DEVICE, AND SUBSTRATE TREATMENT DEVICE**

(30) Priority: 18.12.2019 JP 2019228056; 24.09.2020 JP 2020159966
(71) Applicant: Ebara Corporation, Tokyo 144-8510 (JP)
(72) Inventor: YAZAWA, Akihiro, Tokyo 144-8510 (JP); KOBAYASHI, Kenichi, Tokyo 144-8510 (JP)
(74) Representative: Wimmer, Hubert
(86) International application number: PCT/JP2020/042722
(87) International publication number: WO 2021/124761

(57) **Abstract**

To reduce a contact area between a substrate and a pusher, and to improve safety and reliability of reception of the substrate. A pusher 230 includes: a plurality of support pillars 272 having one ends and support surfaces 272a for supporting a substrate WF on the one ends; a base 274 coupled to other ends of the plurality of support pillars 272; and a first elevating mechanism 233 configured to move the base 274 up and down. The support surface 272a is configured to support the substrate WF when the substrate WF is gripped or released to a top ring 302 and when the substrate WF is received from the top ring 302. At least one of the plurality of support pillars 272 include a suction passage 272b communicating with a vacuum source 260 and opening to the support surface 272a.

## Description

### TECHNICAL FIELD

This application relates to a pusher, a substrate transfer apparatus, and a substrate processing apparatus. This application claims priorities based on the Japanese patent application No. 2019-228056 filed on December 18, 2019 and Japanese patent application No. 2020-159966 filed on September 24, 2020. The entire disclosure of the Japanese patent application No. 2019-228056 and Japanese patent application No. 2020-159966, including the specifications, the claims, the drawings, and the abstracts is incorporated in this application by reference in its entirety.

### BACKGROUND ART

There has been used a chemical mechanical polishing (CMP) apparatus for planarizing a surface of a substrate in production of a semiconductor device. The substrate used in the production of the semiconductor device is usually in a circular plate shape. Not limited to the semiconductor device, a demand for flatness in planarizing a surface of a square substrate, such as a Copper Clad Laminate substrate (CCL substrate), a Printed Circuit Board (PCB) substrate, a photomask substrate, and a display panel, is also increasing. Also, a demand for planarizing a surface of a package substrate on which an electronic device is arranged, such as a PCB substrate, is increasing.

A CMP apparatus includes a pusher for gripping or releasing a substrate before polishing to a top ring and receiving the substrate after polishing from the top ring. For example, PTL 1 discloses a pusher that includes a plurality of substrate supporting pins for supporting a substrate before polishing and gripping or releasing it to a top ring, and a plurality of columnar-shaped substrate supporting members for receiving the substrate after polishing from the top ring.

PTL 1 discloses a problem that the substrate cannot be peeled off of the top ring because the substrate is closely attached to the top ring due to a surface tension when the substrate after polishing is gripped or released from the top ring to the pusher. For this problem, PTL 1 discloses that an end of the substrate is peeled off of the top ring by inclining the substrate with the pusher suctioning the substrate, and a gas, such as air or nitrogen, is blown into a clearance made between the end of the substrate and the top ring. PTL 1 also discloses that the substrate is peeled off of the top ring by inserting a peeling auxiliary member in a plate shape or a rod shape into the clearance made between the end of the substrate and the top ring.

### CITATION LIST

### PATENT LITERATURE

PTL 1: Japanese Unexamined Patent Application Publication No. 2008-110471

### SUMMARY OF INVENTION

### TECHNICAL PROBLEM

A substrate as a process target has an area (pattern area) in which wiring, a functional chip, and the like are formed, and it is undesirable that a pusher comes into contact with this pattern area. In this respect, the pusher described in PTL 1 possibly increases a contact area between the pusher and the substrate since the substrate supporting pin comes into contact with the substrate before polishing, and the substrate supporting member comes into contact with the substrate after polishing. This is undesirable in terms of increasing a degree of freedom of the pattern area of the substrate.

There has also been known a method for a pusher to receive a substrate from a top ring that causes the substrate to drop to the pusher by cancelling the top ring suctioning the substrate with the pusher being raised to the proximity of the substrate, however, the substrate could be damaged by impact of dropping in this case. In contrast to this, it is also conceivable to safely receive the substrate without damage by raising the pusher until it comes into contact with the substrate, and cancelling the top ring suctioning the substrate with the pusher being in contact with the substrate. However, with this method, the substrate may stick to the top ring, and thus, the pusher could fail to surely receive the substrate.

There is a room for improvement in relation to increased reliability of gripping or releasing of the substrate from the top ring to the pusher in the technique disclosed in PTL 1. That is, the technique described in PTL 1 is to peel the substrate off with a force smaller than that when the whole substrate is peeled off of the top ring by inclining the substrate to peel the end of the substrate off of the top ring. However, when the surface tension between the top ring and the substrate is large, it may fail to peel the end of the substrate off of the top ring even though the substrate is inclined, and thus, it may fail to grip or release the substrate to the pusher.

The object of this application is to solve or reduce at least one of the above-described problems.

As one example, one object of this application is to reduce a contact area between a substrate and a pusher, and to improve safety and reliability of reception of the substrate. Additionally, as one example, one object of this application is to improve reliability of gripping or releasing of the substrate from a top ring to the pusher.

### SOLUTION TO PROBLEM

According to one embodiment, a pusher is disclosed. The pusher includes a plurality of first support pillars, a first base, and a first elevating mechanism. The plurality of first support pillars have one ends and support surfaces for supporting a substrate on the one ends. The first base is coupled to other ends of the plurality of first support pillars. The first elevating mechanism is configured to move the first base up and down. The support surface is configured to support the substrate when the substrate is gripped or released to a top ring and when the substrate is received from the top ring. At least one of the plurality of first support pillars is formed with a suction passage communicating with a vacuum source and opening to the support surface.

According to one embodiment, a substrate processing apparatus is disclosed. The substrate processing apparatus includes a top ring, a pusher, and a wedge mechanism. The top ring is configured to hold a back surface of a substrate with a surface to be polished facing downward. The pusher is configured to grip or release a substrate between the pusher and the top ring. The wedge mechanism includes a wedge member arranged at a side of the substrate held onto the top ring when the substrate is gripped or released from the top ring to the pusher, and a driving member configured to move the wedge member in a direction along the back surface of the substrate to insert the wedge member between the back surface of the substrate and the top ring.

### BRIEF DESCRIPTION OF DRAWINGS

Fig. 1 is a plan view illustrating an overall configuration of a substrate processing apparatus according to one embodiment.
Fig. 2 is a plan view schematically illustrating a substrate as a process target according to one embodiment.
Fig. 3 is a perspective view schematically illustrating a polishing module according to one embodiment.
Fig. 4 is a cross-sectional side view schematically illustrating a structure of a top ring according to one embodiment.
Fig. 5 is a side view schematically illustrating a transfer module according to one embodiment.
Fig. 6 is a perspective view illustrating the transfer module according to one embodiment.
Fig. 7 is a perspective view illustrating a pusher according to one embodiment.
Fig. 8 is a partial cross-sectional view viewing the pusher illustrated in Fig. 7 in a direction of an arrow 8.
Fig. 9 is a cross-sectional view illustrating one of support pillars of a second stage according to one embodiment.
Fig. 10 is a cross-sectional view illustrating one of support pillars of a first stage according to one embodiment.
Fig. 11 is a partial cross-sectional view illustrating when the first stage and the second stage are at upper positions.
Fig. 12 is a partial cross-sectional view illustrating when the first stage and the second stage are at the upper positions, and moreover, the first stage is at a position raised with respect to the second stage.
Fig. 13 is a side view schematically illustrating a transfer module according to one embodiment.
Fig. 14 is a view viewing the transfer module illustrated in Fig. 13 in a direction of an arrow 14.
Fig. 15 is a plan view illustrating an overall configuration of a substrate processing apparatus according to one embodiment.
Fig. 16 is a perspective view schematically illustrating a polishing module according to one embodiment.
Fig. 17 is a cross-sectional side view schematically illustrating a structure of a top ring according to one embodiment.
Fig. 18 is a side view schematically illustrating a transfer module according to one embodiment.
Fig. 19 is a perspective view illustrating a transfer module according to one embodiment.
Fig. 20 is a perspective view illustrating a pusher according to one embodiment.
Fig. 21 is a partial cross-sectional view viewing the pusher illustrated in Fig. 20 in a direction of an arrow 21.
Fig. 22 is a cross-sectional view illustrating one of support pillars of a second stage according to one embodiment.
Fig. 23 is a cross-sectional view illustrating one of support pillars of a first stage according to one embodiment.
Fig. 24 is a perspective view schematically illustrating a wedge mechanism according to one embodiment.
Figs. 25(A) to 25(C) are plan views and a cross-sectional view schematically illustrating the wedge mechanism according to one embodiment.
Fig. 26 is a cross-sectional view schematically illustrating a wedge mechanism in a modification example.
Fig. 27 is a cross-sectional view schematically illustrating an inclination mechanism according to one embodiment.
Fig. 28 is a cross-sectional view schematically illustrating the inclination mechanism according to one embodiment.
Fig. 29 is a cross-sectional view schematically illustrating the inclination mechanism according to one embodiment.
Fig. 30 is a cross-sectional view schematically illustrating the inclination mechanism according to one embodiment.

### DESCRIPTION OF EMBODIMENTS

The following describes embodiments of a pusher, a substrate transfer apparatus, and a substrate processing apparatus according to the present invention with reference to the attached drawings. In the attached drawings, identical or similar reference numerals are attached to identical or similar components, and overlapping description regarding the identical or similar components may be omitted in the description of the respective embodiments. Features illustrated in the respective embodiments are applicable to other embodiments in so far as they are consistent with one another.

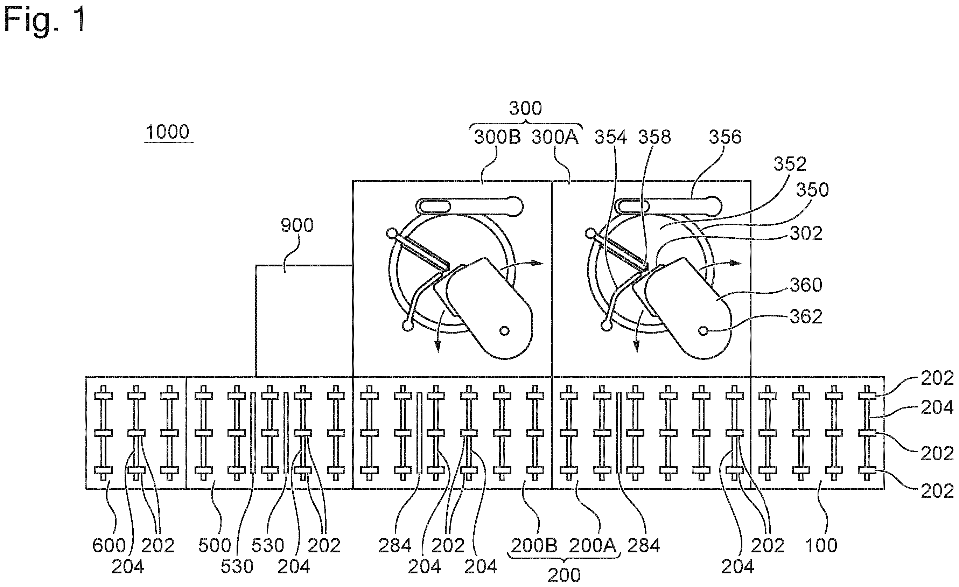

Fig. 1 is a plan view illustrating an overall configuration of a substrate processing apparatus 1000 according to one embodiment. The substrate processing apparatus 1000 illustrated in Fig. 1 has a load module 100, a transfer module 200, a polishing module 300, a drying module 500, and an unload module 600. In the illustrated embodiment, the transfer module 200 has two transfer modules 200A and 200B, and the polishing module 300 has two polishing modules 300A and 300B. In one embodiment, each of these modules can be independently formed. Independently forming these modules can easily form the substrate processing apparatus 1000 having a different configuration by conveniently combining the numbers of the respective modules. The substrate processing apparatus 1000 also includes a control device 900, and the control device 900 controls each component of the substrate processing apparatus 1000. In one embodiment, the control device 900 can be configured of a general computer including, for example, an input and output device, an arithmetic device, and a storage device.

### <Load Module>

The load module 100 is a module for introducing a substrate WF before undergoing processes, such as polishing and cleaning, into the substrate processing apparatus 1000. In one embodiment, the load module 100 is configured to comply with Mechanical Equipment Interface Standard (IPC-SMEMA-9851) of Surface Mount Equipment Manufacturers Association (SMEMA).

In the illustrated embodiment, the transfer mechanism of the load module 100 has a plurality of transfer rollers 202 (first transfer rollers) and a plurality of roller shafts 204 to which the transfer rollers 202 are mounted. In the embodiment illustrated in Fig. 1, each roller shaft 204 is mounted with three transfer rollers 202. The substrate WF is arranged on the transfer rollers 202, and the substrate WF is transferred as the transfer rollers 202 rotate. The installation positions of the transfer rollers 202 on the roller shafts 204 can be anywhere as long as the substrate WF can be stably transferred. However, since the transfer rollers 202 come into contact with the substrate WF, the transfer rollers 202 should be arranged such that the transfer rollers 202 come into contact with areas having no problem if contacting the substrate WF as a process target. In one embodiment, the transfer rollers 202 of the load module 100 can be configured of conductive polymer. In one embodiment, the transfer rollers 202 are electrically grounded via the roller shafts 204 and the like. This is for preventing an electronic device and the like on the substrate WF from getting damaged due to the electrically charged substrate WF. Additionally, in one embodiment, the load module 100 may be provided with an ionizer (not illustrated) for preventing the substrate WF from getting electrically charged.

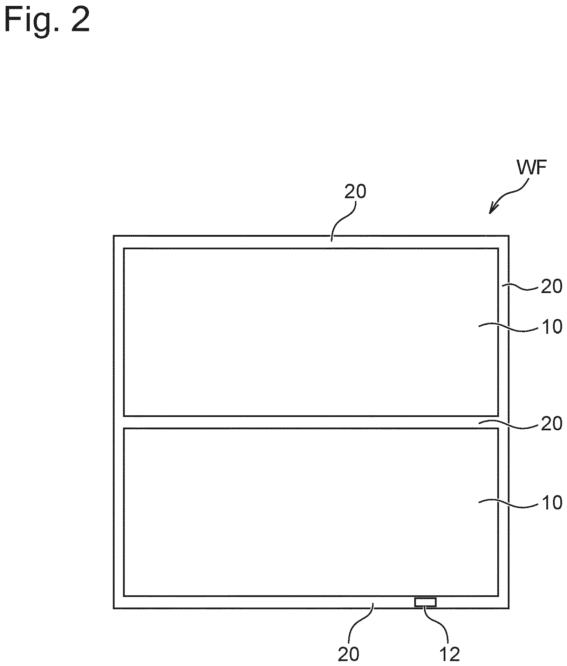

Fig. 2 is a plan view schematically illustrating the substrate WF as a process target according to one embodiment. As illustrated in Fig. 2, in one embodiment, the substrate WF is a thin plate-shaped substrate in an approximately rectangular shape (including a square shape). The substrate WF illustrated in Fig. 2 includes pattern areas 10 and a non-pattern area 20. The "pattern area" is an area including wiring, a functional chip, and the like, is an area used as a device formed on the substrate, and includes the wiring, the functional chip, and the like meaningful to the function of the device. The "non-pattern area" is an area not used as a device on the substrate. In the embodiment illustrated in Fig. 2, the substrate WF includes two pattern areas 10, and the pattern areas 10 are each surrounded by the non-pattern area 20. In one embodiment, the substrate WF can include ID information of the substrate WF in the non-pattern area 20, and, for example, it is possible to include an ID tag 12 and the like. An ID of the substrate WF can be readable by an ID reader provided in the load module 100.

The load module 100 receives and transfers the substrate WF such that the surface on which the pattern area 10 of the substrate WF illustrated in Fig. 2 is formed faces downward. Therefore, the transfer rollers 202 are arranged so as to be in contact only with the non-pattern area 20 of the substrate WF. Specifically, the transfer rollers 202 are provided at positions that come in contact with the non-pattern area 20 at the ends of the substrate WF and positions that come into contact with the non-pattern area 20 at the center of the substrate WF. The positions of the transfer rollers 202 can be changed depending on the substrate WF as a process target. Therefore, with the illustrated embodiment, changing the installation positions of the transfer rollers 202 to the roller shafts 204 ensures usage in transferring the substrate WF having a different dimension and a different pattern. A square substrate does not have dimensions determined by standards like a circular-shaped semiconductor substrate. Therefore, the transfer mechanism according to the embodiment of this disclosure has an advantage as it can transfer substrates having various dimensions with slight changes.

### <Polishing Module>

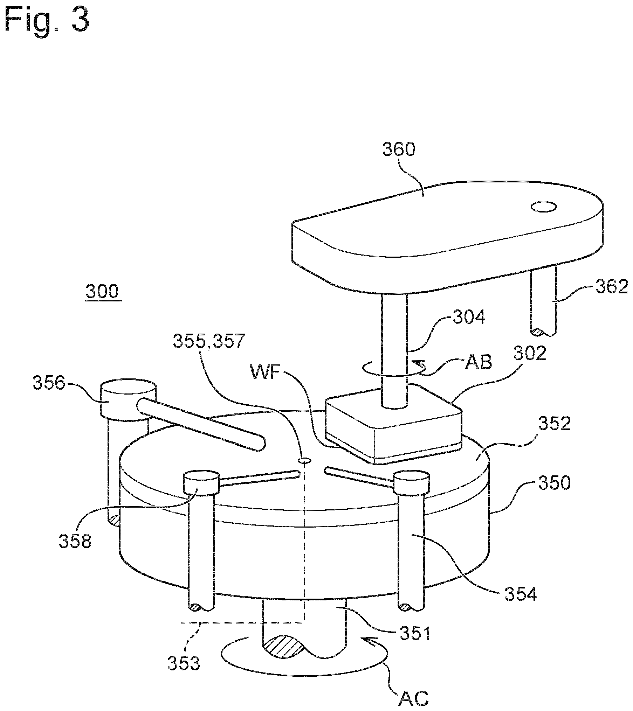

Fig. 3 is a perspective view schematically illustrating the polishing module 300 according to one embodiment. The substrate processing apparatus 1000 illustrated in Fig. 1 includes the two polishing modules 300A and 300B. The two polishing modules 300A and 300B can have the identical configurations, and therefore, a description will be given collectively as the polishing module 300 below.

As illustrated in Fig. 3, the polishing module 300 includes a polishing table 350 and a top ring 302. The polishing table 350 is supported by a table shaft 351. The polishing table 350 is rotated about a shaft center of the table shaft 351 as indicated by an arrow AC by a driver, which is not illustrated. The polishing table 350 is attached with a polishing pad 352. The top ring 302 holds the substrate WF and presses it onto the polishing pad 352. The top ring 302 is rotatably driven by a driving source, which is not illustrated. The substrate WF is polished by being held by the top ring 302 and pressed onto the polishing pad 352.

As illustrated in Fig. 3, the polishing module 300 includes a polishing liquid supply nozzle 354 for supplying a polishing liquid or a dressing liquid to the polishing pad 352. The polishing liquid is, for example, slurry. The dressing liquid is, for example, pure water. As illustrated in Fig. 3, the polishing table 350 and the table shaft 351 are provided with a passage 353 for supplying the polishing liquid. The passage 353 communicates with an opening 355 on a surface of the polishing table 350. The polishing pad 352 has a through-hole 357 formed at a position corresponding to the opening 355 of the polishing table 350, and the polishing liquid that passes through the passage 353 is supplied from the opening 355 of the polishing table 350 and the through-hole 357 of the polishing pad 352 to a surface of the polishing pad 352. The polishing module 300 includes a dresser 356 for conditioning the polishing pad 352. The polishing module 300 includes an atomizer 358 for injecting a liquid or a mixture fluid of a liquid and a gas toward the polishing pad 352. The liquid injected from the atomizer 358 is, for example, pure water, and the gas is, for example, a nitrogen gas.

The top ring 302 is supported by a top ring shaft 304. The top ring 302 is rotated about a shaft center of the top ring shaft 304 as indicated by an arrow AB by a driver, which is not illustrated. The top ring shaft 304 is movable in a vertical direction by a driving mechanism, which is not illustrated.

The substrate WF is held on a surface opposed to the polishing pad 352 of the top ring 302 by vacuum suctioning. During polishing, the polishing liquid is supplied from the polishing liquid supply nozzle 354 and/or from the through-hole 357 of the polishing pad 352 to the polishing surface of the polishing pad 352. Also, during polishing, the polishing table 350 and the top ring 302 are rotatably driven. The substrate WF is polished by being pressed onto the polishing surface of the polishing pad 352 by the top ring 302.

As illustrated in Fig. 3, the top ring shaft 304 is coupled to an arm 360, and the arm 360 is swingable about a rotation shaft 362. During polishing of the substrate WF, the arm 360 may be fixed or swung such that the top ring 302 passes through the center of the polishing pad 352. Also, during polishing of the substrate WF, the arm 360 may be fixed or swung such that the substrate WF covers the through-hole 357 of the polishing pad 352. As illustrated in Fig. 1, the top ring 302 is movable toward the transfer module 200 because of the swingable arm 360. The top ring 302 moves to a substrate gripping or releasing position of the transfer module 200, which will be described later, and thus, the top ring 302 can receive the substrate WF from a pusher 230, which will be described later. After polishing of the substrate WF by the polishing module 300, the substrate WF can be gripped or released from the top ring 302 to the pusher 230.

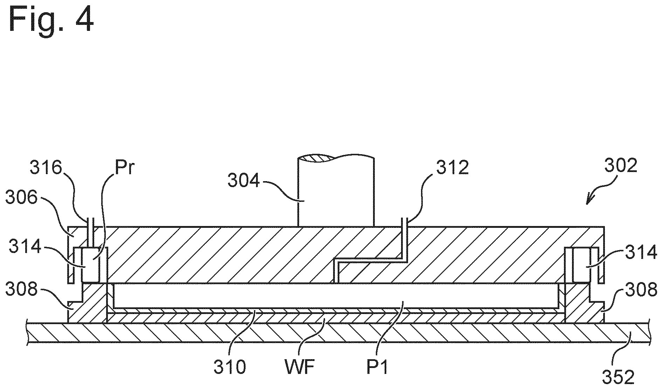

Fig. 4 is a cross-sectional side view schematically illustrating a structure of the top ring 302 according to one embodiment. The top ring 302 is coupled to a lower end of the top ring shaft 304. The top ring 302 includes a head main body 306 in an approximately square shape and a retainer member 308 arranged below the head main body 306. The head main body 306 can be formed of a material with high strength and rigidity, such as metal and ceramic. The retainer member 308 can be formed of a resin material with high rigidity, ceramic, or the like.

In a space formed inside the head main body 306 and the retainer member 308, an elastic pad 310 that abuts on the substrate WF is housed. Between the elastic pad 310 and the head main body 306, a pressure chamber (air bag) P1 is provided. The pressure chamber P1 is formed by the elastic pad 310 and the head main body 306. The pressure chamber P1 is supplied with a pressurized fluid, such as pressurized air, via a fluid path 312 or is vacuum drawn. In the embodiment illustrated in Fig. 4, the pressure chamber P1 is formed over a whole surface of the substrate WF to be held.

The substrate WF has a peripheral end surrounded by the retainer member 308, which stops the substrate WF from ejecting out of the head main body 306 during polishing. There is arranged an elastic bag 314 between the retainer member 308 and the head main body 306, and the elastic bag 314 is internally formed with a pressure chamber Pr. The retainer member 308 is relatively movable in the vertical direction with respect to the head main body 306 by expansion/contraction of the elastic bag 314. A fluid path 316 communicates with the pressure chamber Pr, and the pressurized fluid, such as the pressurized air, is supplied to the pressure chamber Pr through the fluid path 316. The pressure chamber Pr has an adjustable internal pressure. Accordingly, the pressing force to the polishing pad 352 of the retainer member 308 is adjustable independently from the pressing force to the polishing pad 352 of the substrate WF.

### <Drying Module>

The drying module 500 is a device for drying the substrate WF. In the substrate processing apparatus 1000 illustrated in Fig. 1, the drying module 500 dries the substrate WF cleaned by a cleaner of the transfer module 200 after being polished in the polishing module 300. As illustrated in Fig. 1, the drying module 500 is arranged at the downstream of the transfer module 200.

The drying module 500 has a nozzle 530 for injecting a gas toward the substrate WF transferred on the transfer rollers 202. The gas can, for example, be compressed air or nitrogen. Blowing water droplets on the transferred substrate WF off by the drying module 500 ensures drying the substrate WF.

### <Unload Module>

The unload module 600 is a module for unloading the substrate WF after undergoing the processes, such as polishing and cleaning, out of the substrate processing apparatus 1000. In the substrate processing apparatus 1000 illustrated in Fig. 1, the unload module 600 receives the substrate after being dried in the drying module 500. As illustrated in Fig. 1, the unload module 600 is arranged at a downstream of the drying module 500. In one embodiment, the unload module 600 is configured so as to comply with Mechanical Equipment Interface Standard (IPC-SMEMA-9851) of Surface Mount Equipment Manufacturers Association (SMEMA).

### <Transfer Module>

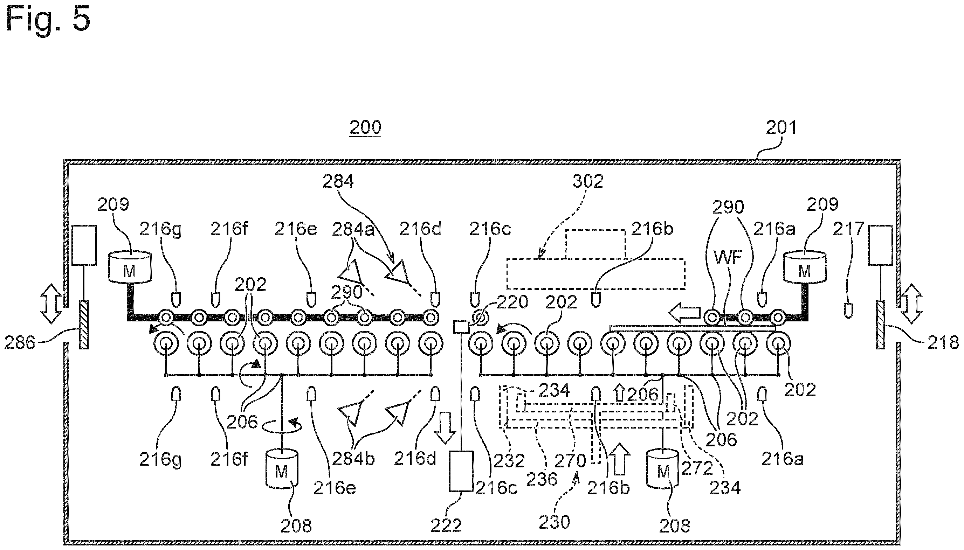

Fig. 5 is a side view schematically illustrating the transfer module 200 according to one embodiment. The substrate processing apparatus 1000 illustrated in Fig. 1 includes the two transfer modules 200A and 200B. Since the two transfer modules 200A and 200B can have the identical configurations, a description will be collectively given as the transfer module 200 below.

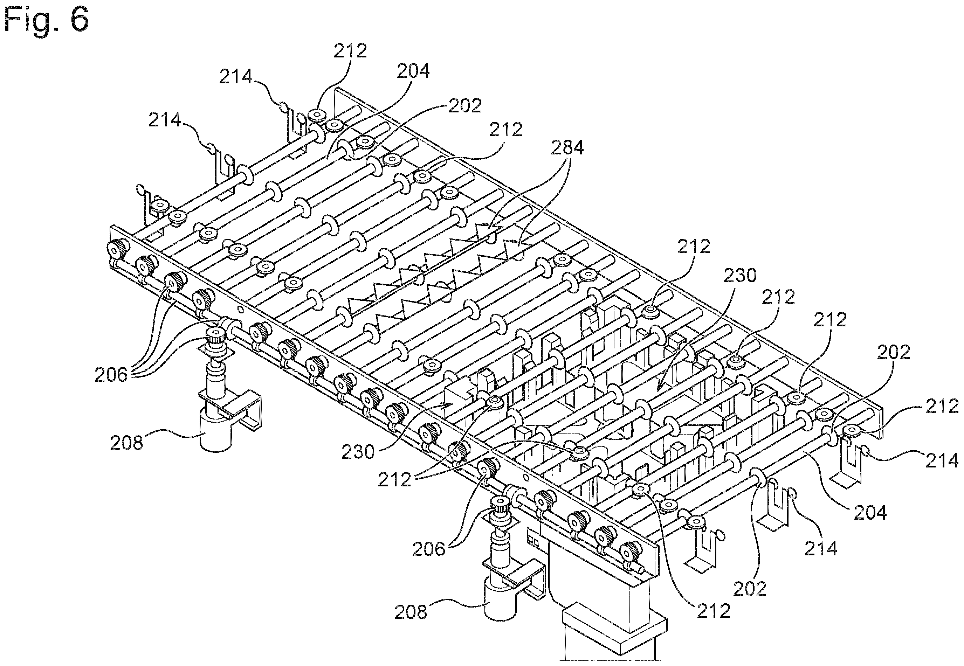

Fig. 6 is a perspective view illustrating the transfer module 200 according to one embodiment. Note that, in Fig. 6, upper transfer rollers (second transfer rollers) 290, which will be described later, and its driving mechanism are omitted for clarification of illustration. The illustrated transfer module 200 includes the plurality of transfer rollers (first transfer rollers) 202 for transferring the substrate WF. Rotating the transfer rollers 202 ensures transferring the substrate WF on the transfer rollers 202 in a predetermined direction. The transfer rollers 202 of the transfer module 200 may be formed of conductive polymer or may be formed of polymer without conductive property. The transfer rollers 202 are mounted on the roller shafts (first roller shafts) 204, and are driven by a motor 208 via a gear 206. In one embodiment, the motor 208 can be a servo motor, the gear 206 can be a gear type or can also be a magnet gear. The illustrated transfer module 200 includes a guide roller 212 that supports a side surface of the substrate WF during transfer. The illustrated transfer module 200 has a sensor 216 for detecting presence/absence of the substrate WF at the predetermined position on the transfer rollers 202. The sensor 216 can be a sensor of any format, and, for example, can be an optical sensor. In the embodiment illustrated in Fig. 5, seven sensors 216 (216a to 216g) are provided in the transfer module 200. In one embodiment, the operation of the transfer module 200 can be controlled according to the detection of the substrate WF by these sensors 216a to 216g. Positions and roles of these respective sensors 216a to 216g will be described later. As illustrated in Fig. 5, the transfer module 200 has an inlet shutter 218 openable/closable for receiving the substrate WF in the transfer module 200.

As illustrated in Fig. 5, the transfer module 200 has a stopper 220. The stopper 220 is connected to a stopper moving mechanism 222, and the stopper 220 is allowed to enter into a transfer path of the substrate WF moving on the transfer rollers 202. When the stopper 220 is positioned in the transfer path of the substrate WF, the side surface of the substrate WF moving on the transfer rollers 202 comes into contact with the stopper 220, and the substrate WF on the move can be stopped at the position of the stopper 220. When the stopper 220 is at the position evacuated from the transfer path of the substrate WF, the substrate WF can be moved on the transfer rollers 202. The stop position of the substrate WF by the stopper 220 is a position where the pusher 230, which will be described below, can receive the substrate WF on the transfer rollers 202 (the substrate gripping or releasing position).

The sensor 216a is provided at an inlet side of the transfer module 200. When the sensor 216a confirms that a back of the substrate WF has passed, the inlet shutter 218 can be closed. Then, while monitoring the position of the substrate WF by the sensor 216b arranged at a downstream of the sensor 216a, the transfer rollers 202 transfer the substrate WF. At this time, the stopper 220 is moved inside the transfer path of the substrate WF by the stopper moving mechanism 222. The substrate WF transferred on the transfer rollers 202 comes into contact with the stopper 220, and the substrate WF is stopped. The sensor 216c is arranged at the position of the stopper 220, and the operation of the transfer rollers 202 is stopped when the substrate WF is detected by the sensor 216c. The substrate WF stopped at the position of the stopper 220 (the substrate gripping or releasing position) is gripped or released to the top ring 302 via the pusher 230, which will be described below.

### <Pusher>

As illustrated in Figs. 5 and 6, the transfer module 200 has the pusher 230. The pusher 230 is configured to be able to lift the substrate WF on the plurality of transfer rollers 202 so as to separate from the plurality of transfer rollers 202. Also, the pusher 230 is configured to be able to grip or release the held substrate WF to the transfer rollers 202 of the transfer module 200.

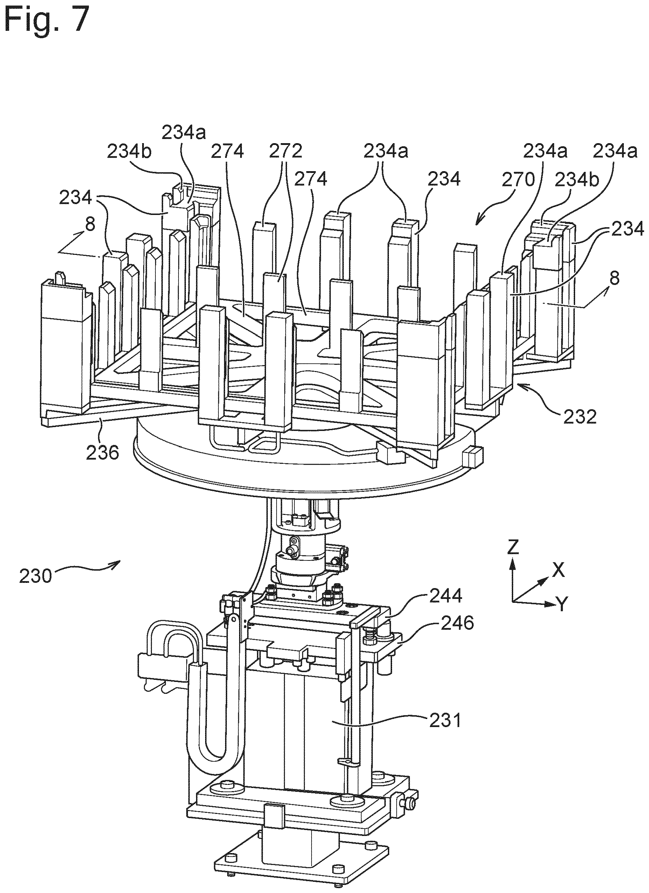

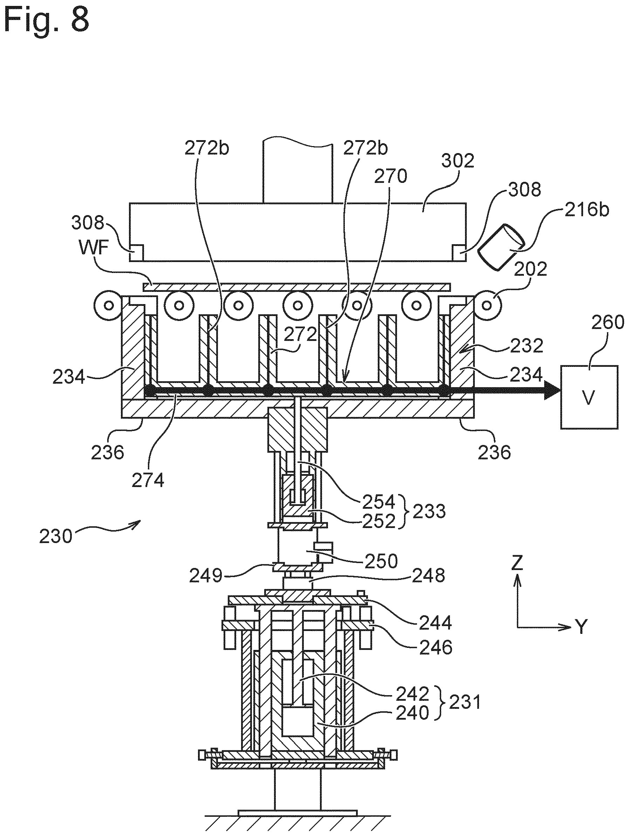

Fig. 7 is a perspective view illustrating the pusher 230 according to one embodiment. Fig. 8 is a partial cross-sectional view viewing the pusher 230 illustrated in Fig. 7 in a direction of an arrow 8. Fig. 8 schematically illustrates the transfer rollers 202, the substrate WF disposed at the substrate gripping or releasing position on the transfer rollers 202, and the top ring 302 that receives the substrate WF, together with the pusher 230. In the embodiment illustrated in Figs. 7 and 8, the pusher 230 includes a first stage 270 and a second stage 232.

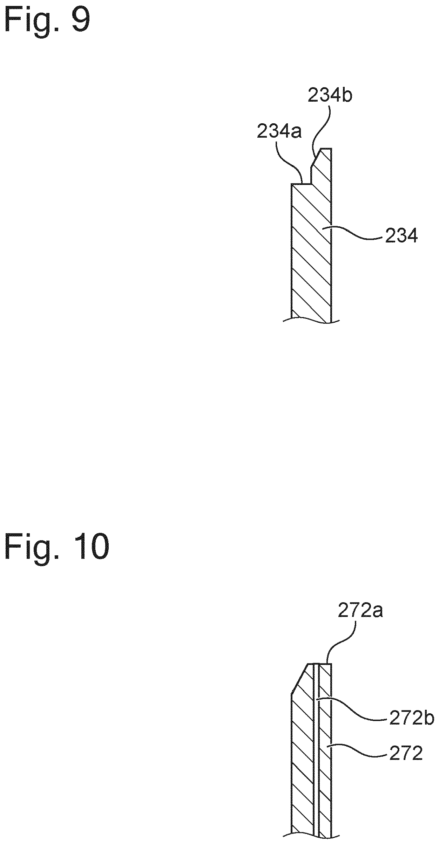

The second stage 232 is a stage for supporting the retainer member 308 of the top ring 302 when the substrate WF is gripped or released from the pusher 230 to the top ring 302, which will be described later. The second stage 232 includes a plurality of support pillars (second support pillars) 234. Fig. 9 is a cross-sectional view illustrating one of the support pillars of the second stage 232 according to one embodiment. As illustrated in Fig. 9, the support pillar 234 has one end having a flat support surface 234a that supports the retainer member 308 of the top ring 302 and an inclined surface 234b for guiding the top ring 302 when the substrate WF is gripped or released to the top ring 302 and when the substrate WF is received from the top ring 302. In one embodiment, the support pillars 234 at four corners among the plurality of support pillars 234 may have the support surfaces 234a and the inclined surfaces 234b as illustrated in Fig. 9. The support pillars 234 at the four corners form depressed portions, which ensure positioning the retainer member 308. The support pillars 234 other than ones at the four corners may have only the support surfaces 234a. The other ends of the respective support pillars 234 are coupled to a common base (second base) 236. Each of the support pillars 234 is provided at a position that does not interfere with the transfer rollers 202, and in the embodiment illustrated in Fig. 8, each of the support pillars 234 is arranged between the transfer rollers 202.

The first stage 270 is configured to receive the substrate WF on the transfer rollers 202. The first stage 270 includes a plurality of support pillars (first support pillars) 272. Fig. 10 is a cross-sectional view illustrating one of the support pillars 272 of the first stage 270 according to one embodiment. As illustrated in Fig. 10, the support pillar 272 has one end having a flat support surface 272a that supports the substrate WF when the substrate WF is gripped or released to the top ring 302 and when the substrate WF is received from the top ring 302. In at least one of the plurality of support pillars 272, a suction passage 272b that opens on the support surface 272a is formed. The suction passage 272b communicates with a vacuum source 260. This configures at least one of the plurality of support pillars 272 to be able to suction the substrate WF via the suction passage 272b when the substrate WF is received from the top ring 302. The other ends of the respective support pillars 272 are coupled to a common base (first base) 274. Each of the support pillars 272 is provided at a position that does not interfere with the transfer rollers 202, and in the embodiment illustrated in Fig. 8, each of the support pillars 272 is arranged between the transfer rollers 202. Each of the support pillars 272 is arranged so as to support the non-pattern area 20 of the substrate WF. The first stage 270 and the second stage 232 are each coupled to an elevating mechanism and each movable in a height direction (z-direction) as will be described in detail below.

The second stage 232 is configured to be movable in the height direction (z-direction). In one embodiment, the pusher 230 has a second elevating mechanism 231. In one embodiment, as illustrated in Figs. 7 and 8, the second elevating mechanism 231 of the pusher 230 is an elevating mechanism of a pneumatic pressure type, and includes a cylinder 240 and a piston 242. The piston 242 has an end coupled to a movable pedestal 244. The cylinder 240 is coupled to a fixed pedestal 246. The fixed pedestal 246 is fixed, for example, to a housing 201 covering the whole transfer module 200 or a floor surface on which the transfer module 200 is installed. Adjusting an air pressure inside the cylinder 240 ensures moving the piston 242 to move the movable pedestal 244 in the height direction (z-direction). The movement of the movable pedestal 244 in the height direction ensures moving the first stage 270 and the second stage 232 in the height direction. In the illustrated embodiment, an XY-stage 248 that can move the first stage 270 and the second stage 232 within a horizontal plane is mounted on the movable pedestal 244. The XY-stage 248 can be a known XY-stage configured to be movable in two perpendicular directions by a linear motion guide or the like. In the illustrated embodiment, a rotary stage 250 is mounted on the XY-stage 248. The rotary stage 250 is configured to be rotatable on an XY-plane (horizontal plane). In other words, the rotary stage 250 is configured to be rotatable about a z-axis. For the rotary stage 250, a known rotary stage 250 configured of, for example, a rotational bearing can be employed.

A first elevating mechanism 233 is mounted on the rotary stage 250. The first elevating mechanism 233 has a cylinder 252 and a piston 254. The cylinder 252 is coupled to the base 236 of the second stage 232. The movable piston 254 is coupled to the cylinder 252, and adjusting an air pressure inside the cylinder 252 ensures moving the piston 254. The piston 254 has an end to which the base 274 of the first stage 270 is coupled. Therefore, adjusting an air pressure inside the cylinder 252 ensures moving the piston 254 and the first stage 270 in the height direction (z-direction). This ensures configuring the first elevating mechanism 233 to, when receiving the substrate WF from the top ring 302, raise the base 274 to bring the support surfaces 272a into contact with the substrate WF and move the base 274 down in a state where the substrate WF is suctioned via the suction passage 272b. Furthermore, the sensor 216b can be configured to detect the presence/absence of the substrate WF on the support surfaces 272a. In this case, the first elevating mechanism 233 can be configured to repeat moving the base 274 up and down in the case where the sensor 216b detects that there is no substrate WF in the state where the base 274 is moved down when receiving the substrate WF from the top ring 302. That is, in the case where the substrate WF is not normally received from the top ring 302, the first elevating mechanism 233 can raise the base 274 to bring the support surfaces 272a into contact with the substrate WF and move the base 274 down in the state where the substrate WF is suctioned via the suction passage 272b, again.

With the above-described configuration, the second elevating mechanism 231 can move both the first stage 270 and the second stage 232 in the height direction (z-direction), and the first elevating mechanism 233 can move the first stage 270 in the height direction (z-direction) with respect to the second stage 232. The first stage 270 and the second stage 232 are movable in the two perpendicular directions (xy-directions) within the horizontal plane by the XY-stage 248. Furthermore, the first stage 270 and the second stage 232 are rotatable within the horizontal plane (about the z-axis) by the rotary stage 250. Therefore, when the substrate WF is transmitted and received between the pusher 230 and the top ring 302, which will be described later, the pusher 230 and the top ring 302 can be positioned. Note that, while in the illustrated embodiment, the first elevating mechanism 233 and the second elevating mechanism 231 are elevating mechanisms of a pneumatic pressure type, these elevating mechanisms may be of a fluid pressure type or may be elevating mechanisms of an electrically operated type using, for example, a motor and a ball screw. The second elevating mechanism 231 ensures moving the second stage 232 and the first stage 270 between a lower position and an upper position.

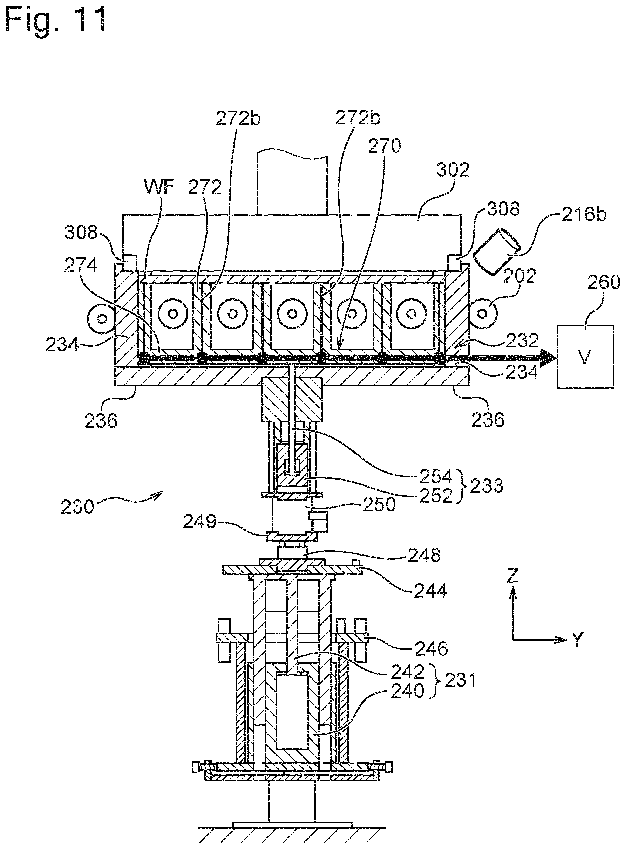

Next, a description will be given of the gripping or releasing of the substrate WF by the pusher 230. Fig. 8 illustrates when the first stage 270 and the second stage 232 are at the lower positions. When the first stage 270 and the second stage 232 are at the lower positions, as illustrated in Fig. 8, the ends of the support pillars 234 of the second stage 232 and the ends of the support pillars 272 of the first stage 270 are at positions lower than surfaces of the transfer rollers 202 supporting the substrate WF. When the substrate WF is gripped or released to the top ring 302, the pusher 230 brings the support surfaces 272a of the support pillars 272 into contact with the substrate WF and lifts the substrate WF by raising the first stage 270 and the second stage 232 with the second elevating mechanism 231 from the state illustrated in Fig. 8, and thus obtaining the state illustrated in Fig. 11.

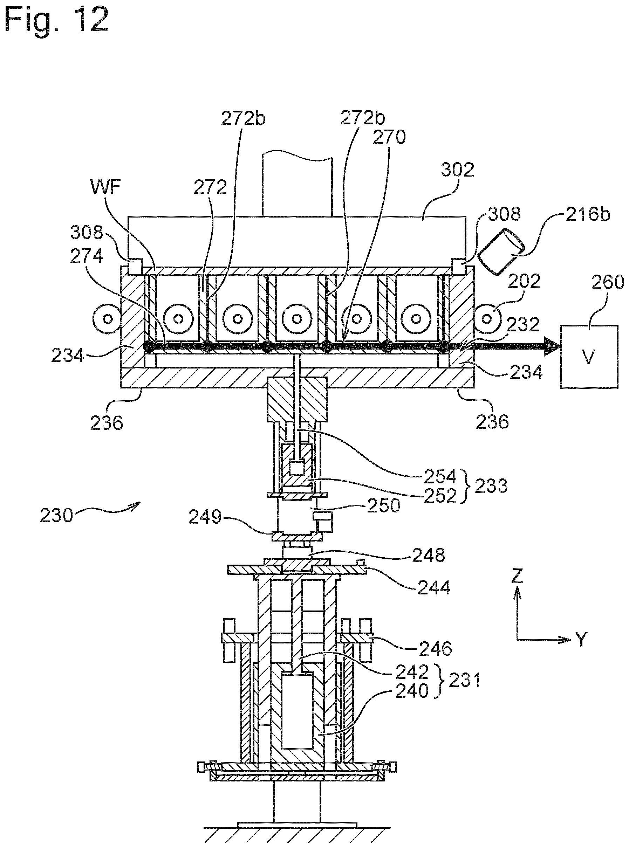

Fig. 11 illustrates when the first stage 270 and the second stage 232 are at the upper positions. When the first stage 270 and the second stage 232 are at the upper positions, the ends of the support pillars 234 of the second stage 232 and the ends of the support pillars 272 of the first stage 270 are at positions higher than the surfaces of the transfer rollers 202 supporting the substrate. That is, when the second stage 232 and the first stage 270 move from the lower positions to the upper positions, the substrate WF disposed on the transfer rollers 202 can be lifted and received by the first stage 270. In the state illustrated in Fig. 11, the support surfaces 234a of the support pillars 234 support the retainer member 308 of the top ring 302. The pusher 230 raises the first stage 270 with respect to the second stage 232 with the first elevating mechanism 233 from the state illustrated in Fig. 11, and thus obtaining the state illustrated in Fig. 12.

Fig. 12 illustrates when the first stage 270 and the second stage 232 are at the upper positions, and furthermore, the first stage 270 is at a position raised with respect to the second stage 232. When the substrate WF is gripped or released from the pusher 230 to the top ring 302, the pusher 230 raises the first stage 270 holding the substrate WF with respect to the second stage 232, as illustrated in Fig. 12. In view of this, the substrate WF comes into contact with the top ring 302 as illustrated in Fig. 12. By vacuum drawing the pressure chamber P1 of the top ring 302 in this state, the substrate WF is suctioned by the top ring 302 and the substrate WF is gripped or released to the top ring 302. After gripping or releasing of the substrate WF to the top ring 302, the pusher 230 returns to the state illustrated in Fig. 8. When the substrate WF is gripped or released to the top ring 302, the vacuum drawing by the vacuum source 260 is stopped.

On the other hand, when the pusher 230 receives the substrate WF from the top ring 302, the pusher 230 transitions from the state illustrated in Fig. 8 to the state illustrated in Fig. 11, then, transitions from the state illustrated in Fig. 11 to the state illustrated in Fig. 12. That is, the pusher 230 brings the support surfaces 272a into contact with the substrate WF by moving the base 274 up with the first elevating mechanism 233 as illustrated in Fig. 12. In the state of Fig. 12, the vacuum drawing from the pressure chamber P1 of the top ring 302 is stopped and the vacuum drawing by the vacuum source 260 is started. In view of this, the substrate WF is suctioned on the support surfaces 272a via the suction passage 272b. The pusher 230 moves the base 274 down with the first elevating mechanism 233 in the state where the substrate WF is suctioned on the support surface 272a, and thus obtaining the state illustrated in Fig. 11.

In the state illustrated in Fig. 11, the sensor 216b detects the presence/absence of the substrate WF on the support surfaces 272a. When it is determined that there is no substrate WF on the support surfaces 272a, the pusher 230 raises the base 274 with the first elevating mechanism 233 again to perform the receiving operation of the substrate WF. The pusher 230 can repeat a retry of the receiving operation of the substrate WF when it is determined that there is no substrate WF on the support surfaces 272a for the number of times having been preliminarily set. When it is determined that there is no substrate WF on the support surfaces 272a even after repeating the retry of the receiving operation of the substrate WF for the preliminarily set number of times, it is possible to cause the substrate processing apparatus 1000 to activate an alarm and stop the substrate processing apparatus 1000.

On the other hand, when it is determined that there is the substrate WF on the support surfaces 272a, the pusher 230 stops the vacuum drawing by the vacuum source 260 and moves the first stage 270 down and the second stage 232 using the second elevating mechanism 231, and thus placing the substrate WF on the transfer rollers 202 and then obtaining the state illustrated in Fig. 8.

With the embodiment, when the substrate WF is gripped or released and received to/from the top ring 302, only the support surfaces 272a of the support pillars 272 in the pusher 230 come into contact with the substrate WF, thereby ensuring a reduced contact area between the pusher 230 and the substrate WF. This ensures increasing a degree of freedom of the pattern area of the substrate WF. Also, since the substrate WF is received from the top ring 302 with the pusher 230 being raised until it comes into contact with the substrate WF, the substrate WF can be received safely without damage compared with a case where the substrate WF is dropped to the pusher 230. Furthermore, since the substrate WF is suctioned via the suction passage 272b formed in the support pillars 272 when the substrate WF is received, the pusher 230 can surely receive the substrate WF.

The transfer module 200 illustrated in Figs. 5 and 6 has the cleaner. As illustrated in Figs. 5 and 6, The cleaner has cleaning nozzles 284. The cleaning nozzles 284 have upper cleaning nozzles 284a arranged above the transfer rollers 202 and lower cleaning nozzles 284b arranged below the transfer rollers 202. The upper cleaning nozzles 284a and the lower cleaning nozzles 284b are connected to a supply source of a cleaning liquid, which is not illustrated. The upper cleaning nozzles 284a are configured to supply the cleaning liquid to an upper surface of the substrate WF transferred on the transfer rollers 202. The lower cleaning nozzles 284b are configured to supply the cleaning liquid to a lower surface of the substrate WF transferred on the transfer rollers 202. The upper cleaning nozzles 284a and the lower cleaning nozzles 284b have widths approximately the same as a width of the substrate WF transferred on the transfer rollers 202 or equal to or larger than that, and are configured to clean the whole surface of the substrate WF as the substrate WF is transferred on the transfer rollers 202. As illustrated in Figs. 5 and 6, the cleaner is positioned at a downstream with respect to the substrate gripping or releasing area of the transfer module 200.

As illustrated in Fig. 5, the upper transfer rollers 290 are arranged above the transfer rollers 202 in the cleaner. The upper transfer rollers 290 is connected to a power source, and is configured to be rotatable. In one embodiment, the upper transfer rollers 290 are configured to be driven by the gear 206 and the motor 208 similarly to the transfer rollers 202.

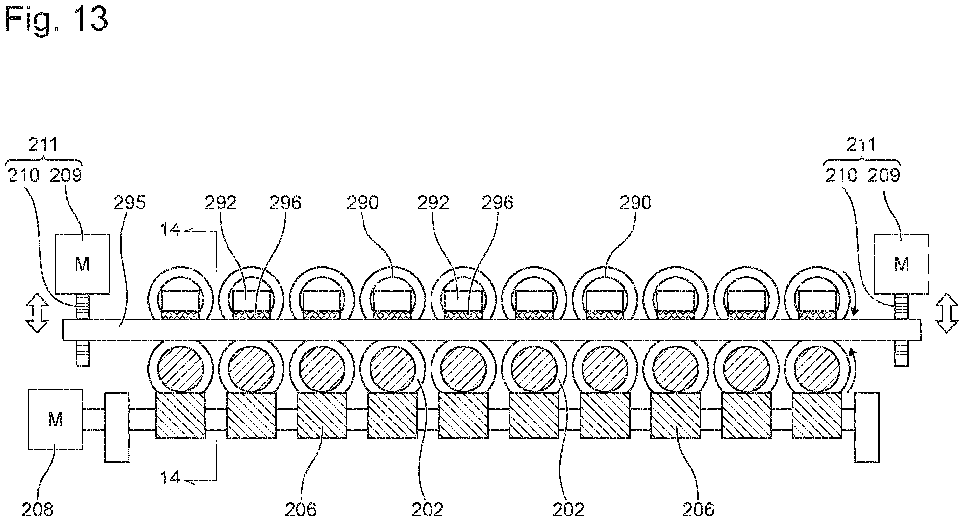

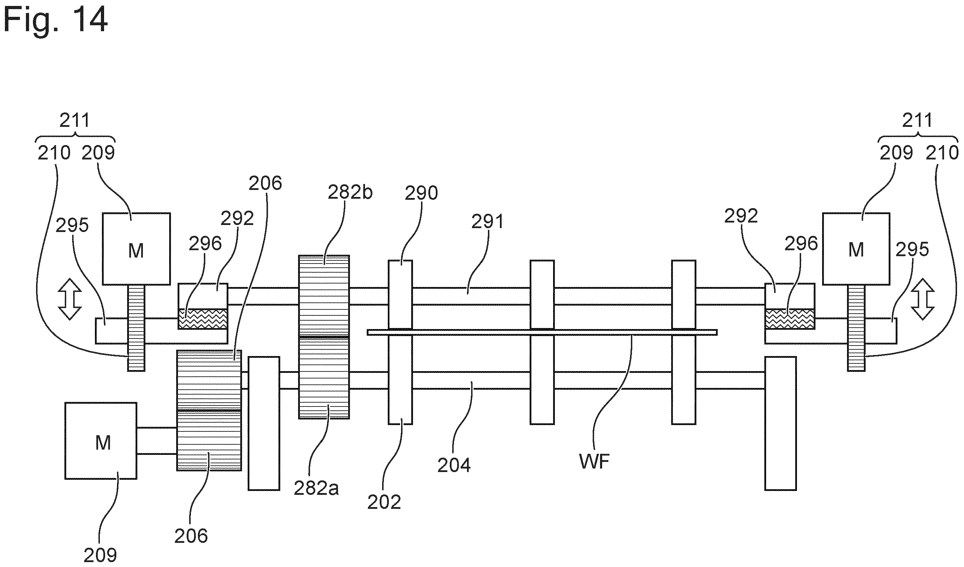

Fig. 13 is a side view schematically illustrating the transfer module according to one embodiment. Fig. 14 is a drawing viewing the transfer module illustrated in Fig. 13 in a direction of an arrow 14. As illustrated in Figs. 13 and 14, the upper transfer rollers 290 are mounted on an upper roller shaft (second roller shaft) 291. In the embodiment illustrated in Fig. 14, three upper transfer rollers 290 are mounted on the upper roller shaft 291. In one embodiment, the upper transfer rollers 290 are arranged with a predetermined interval on the transfer rollers 202. The predetermined interval can be approximately the same as a thickness of the transferred substrate WF. This predetermined interval is adjustable as described later. The upper transfer roller 290 has any dimension, and the dimension may be the same dimension as that of the transfer roller 202 or may be a different dimension. In one embodiment, as illustrated in Figs. 13 and 14, the upper transfer roller 290 has a diameter smaller than a diameter of the transfer roller 202. Decreasing the diameter of the upper transfer roller 290 ensures decreasing a whole dimension of the transfer module 200.

As illustrated in Figs. 13 and 14, a gear 282a is mounted on the roller shaft 204, and a gear 282b is mounted on the upper roller shaft 291. The rotational force of the roller shaft 204 is transmitted to the upper roller shaft 291 via the gears 282a and 282b. In one embodiment, the gears 282a and 282b can be magnet gears or may be mechanical gears. Corresponding to the dimensions of the transfer roller 202 and the upper transfer roller 290, the gears 282a and 282b can be adjusted to have appropriate rotation speeds of the transfer rollers 202 and the upper transfer rollers 290, and sizes and specifications of the respective gears can be changed.

The upper roller shaft 291 has both ends coupled to supporting members 292. A plurality of the upper roller shafts 291 have both sides provided with bases 295 extending in a transferring direction to the substrate WF. An elastic member 296, such as a spring, is provided between an upper surface of the base 295 and a lower surface of the supporting member 292, and the elastic member 296 biases the supporting member 292 toward the base 295. Therefore, the supporting member 292 is movable in an upward direction even though it is biased toward the base 295 by the elastic member 296.

As illustrated in Fig. 5, the transfer module 200 includes a thickness sensor 217 that measures a thickness of the substrate WF. The thickness sensor 217 is arranged in the proximity of an inlet of the transfer module 200, and is configured to measure the thickness of the substrate WF loaded into the transfer module 200. The transfer module 200 includes driving devices 211 that, corresponding to a measurement result by the thickness sensor 217, move at least one of the positions of the transfer rollers 202 and the upper transfer rollers 290 to adjust the interval between the transfer rollers 202 and the upper transfer rollers 290 opposed to one another. In the embodiment of Figs. 13 and 14, the driving device 211 includes a screw shaft 210 screwed into the base 295 and a motor 209 that rotatably drives the screw shaft 210. The driving device 211 can drive the position of the base 295 in the vertical direction by rotatably driving the motor 209 corresponding to the thickness of the substrate WF measured by the thickness sensor 217, and accordingly, can adjust the interval between the transfer rollers 202 and the upper transfer rollers 290.

For example, the driving device 211 moves the position of the base 295 down to narrow the interval between the transfer rollers 202 and the upper transfer rollers 290 when the thickness of the substrate WF measured by the thickness sensor 217 is thin. On the other hand, the driving device 211 raises the position of the base 295 to increase the interval between the transfer rollers 202 and the upper transfer rollers 290 when the thickness of the substrate WF measured by the thickness sensor 217 is thick. With the embodiment, even when various substrates WF having various thicknesses are treated or when the substrate WF has warpage, the upper transfer rollers 290 can be brought into contact with the substrate WF always with an appropriate stress to transmit a rotational force of the upper transfer rollers 290 to the substrate WF, and the substrate WF can be stably transferred by the transfer rollers 202 and the upper transfer rollers 290.

In addition to this, the supporting member 292 is movable in the upward direction while being biased toward the base 295 by the elastic member 296. Therefore, even when the substrate WF to be transferred has unevenness and when the substrate WF has warpage, the upper transfer rollers 290 can always be brought into contact with the substrate WF to transmit a rotational force of the upper transfer rollers 290 to the substrate WF, and the substrate WF can be stably transferred by the transfer rollers 202 and the upper transfer rollers 290. Note that the installation positions of the upper transfer rollers 290 onto the upper roller shaft 291 can be changed corresponding to the dimension of the substrate WF to be transferred with the transfer rollers 202.

In one embodiment, the above-described upper transfer roller 290 can be provided in an area other than the substrate gripping or releasing area. For example, the upper transfer roller 290 can be provided in the cleaner at a downstream of the substrate gripping or releasing area or may be provided at an upstream of the substrate gripping or releasing area. Furthermore, the upper transfer roller 290 may be provided in the above-described load module 100, the drying module 500, which will be described later, and the unload module 600.

As illustrated in Fig. 5, the sensor 216d is arranged in the proximity of the inlet of the cleaner. In one embodiment, when the sensor 216d detects the substrate WF, the cleaning liquid can be injected from the cleaning nozzles 284 to start cleaning the substrate WF. During the cleaning of the substrate WF, a rotating speed of the transfer roller 202 may be at a speed for cleaning. The sensor 216e is arranged inside the cleaner, and thus, while monitoring the position of the substrate WF by the sensor 216e, the substrate WF is transferred while the substrate WF is cleaned. In the embodiment in Fig. 5, the sensor 216f is arranged in the proximity of a cleaner outlet point. In one embodiment, when the sensor 216f detects the substrate WF, the injection of the cleaning liquid from the cleaning nozzle 284 can be terminated. During the cleaning of the substrate WF, the substrate WF is sandwiched between the transfer rollers 202 and the upper transfer rollers 290 and transferred, and therefore, the substrate WF can be stably transferred even during the injection of the cleaning liquid.

As illustrated in Fig. 5, the transfer module 200 has an openable/closable outlet shutter 286. The transfer module 200 includes the sensor 216g in the proximity of the outlet. In one embodiment, when the sensor 216g detects the substrate WF, the outlet shutter 286 may be opened and the substrate WF may be transferred to the next module. In one embodiment, when the sensor 216g detects the substrate WF, the transfer of the substrate WF with the transfer rollers 202 may be stopped without opening the outlet shutter 286, the process of the next module may be waited, after the next module is ready for receiving the substrate, the outlet shutter 286 may be opened, and the substrate WF may be transferred to the next module.

The following describes embodiments of the pusher, the substrate transfer apparatus, and the substrate processing apparatus according to the present invention with reference to the attached drawings. In the attached drawings, identical or similar reference numerals are attached to identical or similar components, and overlapping description regarding the identical or similar components may be omitted in the description of the respective embodiments. Features illustrated in the respective embodiments are applicable to other embodiments in so far as they are consistent with one another.

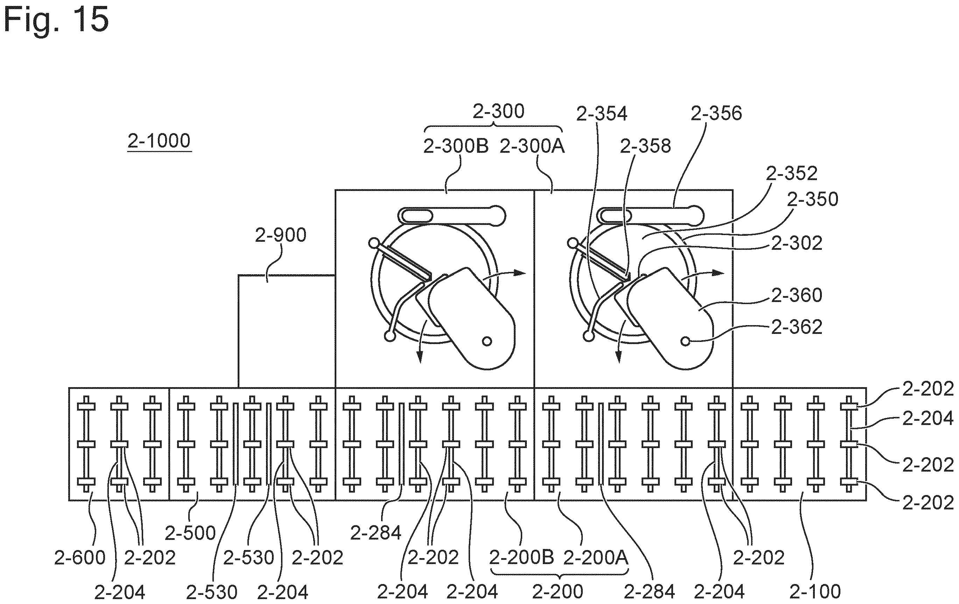

Fig. 15 is a plan view illustrating an overall configuration of a substrate processing apparatus 2-1000 according to one embodiment. The substrate processing apparatus 2-1000 illustrated in Fig. 15 has a load module 2-100, a transfer module 2-200, a polishing module 2-300, a drying module 2-500, and an unload module 2-600. In the illustrated embodiment, the transfer module 2-200 has two transfer modules 2-200A and 2-200B, and the polishing module 2-300 has two polishing modules 2-300A and 2-300B. In one embodiment, each of these modules can be independently formed. Independently forming these modules can easily form the substrate processing apparatus 2-1000 having a different configuration by conveniently combining the numbers of the respective modules. The substrate processing apparatus 2-1000 also includes a control device 2-900, and the control device 2-900 controls each component of the substrate processing apparatus 2-1000. In one embodiment, the control device 2-900 can be configured of a general computer including, for example, an input and output device, an arithmetic device, and a storage device.

### <Load Module>

The load module 2-100 is a module for introducing the substrate WF before undergoing processes, such as polishing and cleaning, into the substrate processing apparatus 2-1000. In one embodiment, the load module 2-100 is configured to comply with Mechanical Equipment Interface Standard (IPC-SMEMA-9851) of Surface Mount Equipment Manufacturers Association (SMEMA).

In the illustrated embodiment, the transfer mechanism of the load module 2-100 has a plurality of transfer rollers 2-202 (first transfer rollers) and a plurality of roller shafts 2-204 to which the transfer rollers 2-202 are mounted. In the embodiment illustrated in Fig. 15, each roller shaft 2-204 is mounted with three transfer rollers 2-202. The substrate WF is arranged on the transfer rollers 2-202, and the substrate WF is transferred as the transfer rollers 2-202 rotate. The installation positions of the transfer rollers 2-202 on the roller shafts 2-204 can be anywhere as long as the substrate WF can be stably transferred. However, since the transfer rollers 2-202 come into contact with the substrate WF, the transfer rollers 2-202 should be arranged such that the transfer rollers 2-202 come into contact with areas having no problem if contacting the substrate WF as a process target. In one embodiment, the transfer rollers 2-202 of the load module 2-100 can be configured of conductive polymer. In one embodiment, the transfer rollers 2-202 are electrically grounded via the roller shafts 2-204 and the like. This is for preventing an electronic device and the like on the substrate WF from getting damaged due to the electrically charged substrate WF. Additionally, in one embodiment, the load module 2-100 may be provided with an ionizer (not illustrated) for preventing the substrate WF from getting electrically charged.

### <Polishing Module>

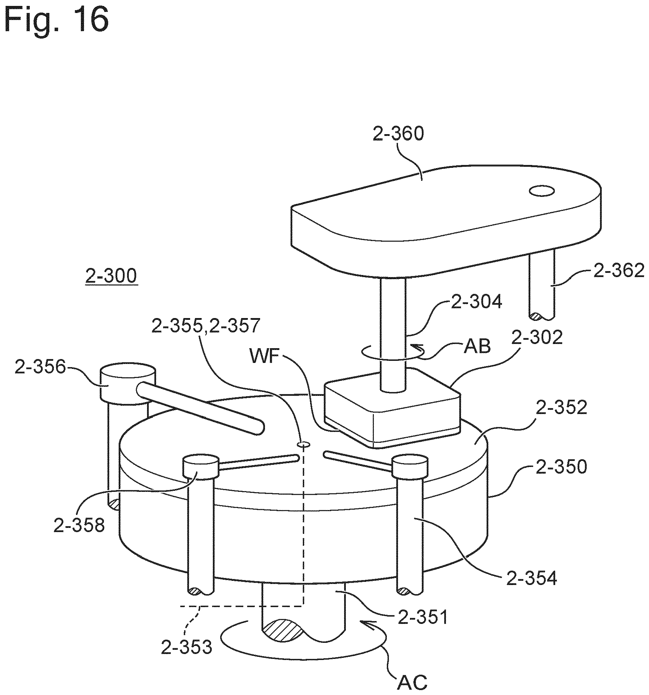

Fig. 16 is a perspective view schematically illustrating the polishing module 2-300 according to one embodiment. The substrate processing apparatus 2-1000 illustrated in Fig. 15 includes the two polishing modules 2-300A and 2-300B. The two polishing modules 2-300A and 2-300B can have the identical configurations, and therefore, a description will be given collectively as the polishing module 2-300 below.

As illustrated in Fig. 16, the polishing module 2-300 includes a polishing table 2-350 and a top ring 2-302. The polishing table 2-350 is supported by a table shaft 2-351. The polishing table 2-350 is rotated about a shaft center of the table shaft 2-351 as indicated by an arrow AC by a driver, which is not illustrated. The polishing table 2-350 is attached with a polishing pad 2-352. The top ring 2-302 holds the substrate WF and presses it onto the polishing pad 2-352. The top ring 2-302 is rotatably driven by a driving source, which is not illustrated. The substrate WF is polished by being held by the top ring 2-302 and pressed onto the polishing pad 2-352.

As illustrated in Fig. 16, the polishing module 2-300 includes a polishing liquid supply nozzle 2-354 for supplying a polishing liquid or a dressing liquid to the polishing pad 2-352. The polishing liquid is, for example, slurry. The dressing liquid is, for example, pure water. As illustrated in Fig. 16, the polishing table 2-350 and the table shaft 2-351 are provided with a passage 2-353 for supplying the polishing liquid. The passage 2-353 communicates with an opening 2-355 on a surface of the polishing table 2-350. The polishing pad 2-352 has a through-hole 2-357 formed at a position corresponding to the opening 2-355 of the polishing table 2-350, and the polishing liquid that passes through the passage 2-353 is supplied from the opening 2-355 of the polishing table 2-350 and the through-hole 2-357 of the polishing pad 2-352 to a surface of the polishing pad 2-352. The polishing module 2-300 includes a dresser 2-356 for conditioning the polishing pad 2-352. The polishing module 2-300 includes an atomizer 2-358 for injecting a liquid or a mixture fluid of a liquid and a gas toward the polishing pad 2-352. The liquid injected from the atomizer 2-358 is, for example, pure water, and the gas is, for example, a nitrogen gas.

The top ring 2-302 is supported by a top ring shaft 2-304. The top ring 2-302 is rotated about a shaft center of the top ring shaft 2-304 as indicated by an arrow AB by a driver, which is not illustrated. The top ring shaft 2-304 is movable in a vertical direction by a driving mechanism, which is not illustrated.

The substrate WF is held on a surface opposed to the polishing pad 2-352 of the top ring 2-302 by vacuum suctioning. During polishing, the polishing liquid is supplied from the polishing liquid supply nozzle 2-354 and/or from the through-hole 2-357 of the polishing pad 2-352 to the polishing surface of the polishing pad 2-352. Also, during polishing, the polishing table 2-350 and the top ring 2-302 are rotatably driven. The substrate WF is polished by being pressed onto the polishing surface of the polishing pad 2-352 by the top ring 2-302.

As illustrated in Fig. 16, the top ring shaft 2-304 is coupled to an arm 2-360, and the arm 2-360 is swingable about a rotation shaft 2-362. During polishing the substrate WF, the arm 2-360 may be fixed or swung such that the top ring 2-302 passes through the center of the polishing pad 2-352. Also, during polishing the substrate WF, the arm 2-360 may be fixed or swung such that the substrate WF covers the through-hole 2-357 of the polishing pad 2-352. As illustrated in Fig. 15, the top ring 2-302 is movable toward the transfer module 2-200 because of the swingable arm 2-360. The top ring 2-302 moves to a substrate gripping or releasing position of the transfer module 2-200, which will be described later, and thus, the top ring 2-302 can receive the substrate WF from a pusher 2-230, which will be described later. After polishing of the substrate WF by the polishing module 2-300, the top ring 2-302 can grip or release the substrate WF to the pusher 2-230.

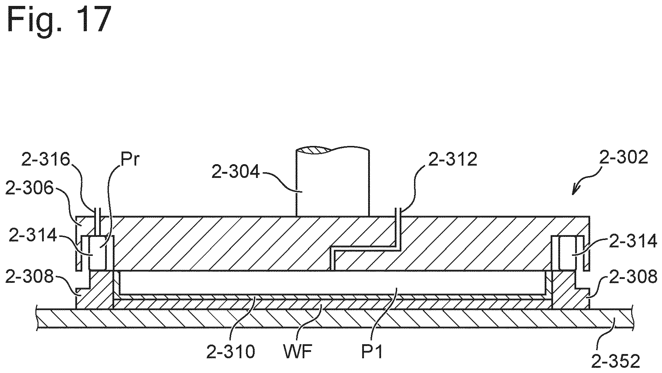

Fig. 17 is a cross-sectional side view schematically illustrating a structure of the top ring 2-302 according to one embodiment. The top ring 2-302 is coupled to a lower end of the top ring shaft 2-304. The top ring 2-302 includes a head main body 2-306 in an approximately square shape and a ring-shaped retainer member 2-308 arranged below the head main body 2-306. The head main body 2-306 can be formed of a material with high strength and rigidity, such as metal and ceramic. The retainer member 2-308 can be formed of a resin material with high rigidity, ceramic, or the like.

In a space formed inside the head main body 2-306 and the retainer member 2-308, an elastic pad 2-310 that abuts on the substrate WF is housed. Between the elastic pad 2-310 and the head main body 2-306, the pressure chamber (air bag) P1 is provided. The pressure chamber P1 is formed by the elastic pad 2-310 and the head main body 2-306. The pressure chamber P1 is supplied with a pressurized fluid, such as pressurized air, via a fluid path 2-312 or is vacuum drawn. In the embodiment illustrated in Fig. 17, the pressure chamber P1 is formed over a whole surface of the substrate WF to be held.

The substrate WF has a peripheral end surrounded by the retainer member 2-308, which stops the substrate WF from ejecting out of the head main body 2-306 during polishing. There is arranged an elastic bag 2-314 between the retainer member 2-308 and the head main body 2-306, and the elastic bag 2-314 is internally formed with the pressure chamber Pr. The retainer member 2-308 is relatively movable in a vertical direction with respect to the head main body 2-306 by expansion/contraction of the elastic bag 2-314. A fluid path 2-316 communicates with the pressure chamber Pr, and the pressurized fluid, such as the pressurized air, is supplied to the pressure chamber Pr through the fluid path 2-316. The pressure chamber Pr has an adjustable internal pressure. Accordingly, the pressing force to the polishing pad 2-352 of the retainer member 2-308 is adjustable independently from the pressing force to the polishing pad 2-352 of the substrate WF.

### <Drying Module>

The drying module 2-500 is a device for drying the substrate WF. In the substrate processing apparatus 2-1000 illustrated in Fig. 15, the drying module 2-500 dries the substrate WF cleaned by a cleaning mechanism of the transfer module 2-200 after being polished in the polishing module 2-300. As illustrated in Fig. 15, the drying module 2-500 is arranged at the downstream of the transfer module 2-200.

The drying module 2-500 has a nozzle 2-530 for injecting a gas toward the substrate WF transferred on the transfer rollers 2-202. The gas can, for example, be compressed air or nitrogen. Blowing water droplets on the transferred substrate WF off by the drying module 2-500 ensures drying the substrate WF.

### <Unload Module>

The unload module 2-600 is a module for unloading the substrate WF after undergoing the processes, such as polishing and cleaning, out of the substrate processing apparatus 2-1000. In the substrate processing apparatus 2-1000 illustrated in Fig. 15, the unload module 2-600 receives the substrate after being dried in the drying module 2-500. As illustrated in Fig. 15, the unload module 2-600 is arranged at a downstream of the drying module 2-500. In one embodiment, the unload module 2-600 is configured so as to comply with Mechanical Equipment Interface Standard (IPC-SMEMA-9851) of Surface Mount Equipment Manufacturers Association (SMEMA).

### <Transfer Module>

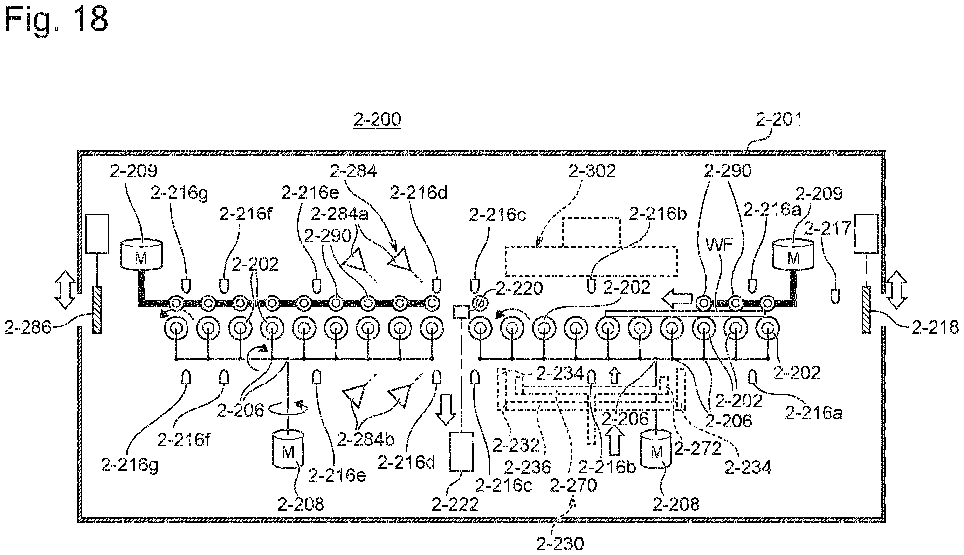

Fig. 18 is a side view schematically illustrating the transfer module 2-200 according to one embodiment. The substrate processing apparatus 2-1000 illustrated in Fig. 15 includes the two transfer modules 2-200A and 2-200B. Since the two transfer modules 2-200A and 2-200B can have the identical configurations, a description will be collectively given as the transfer module 2-200 below.

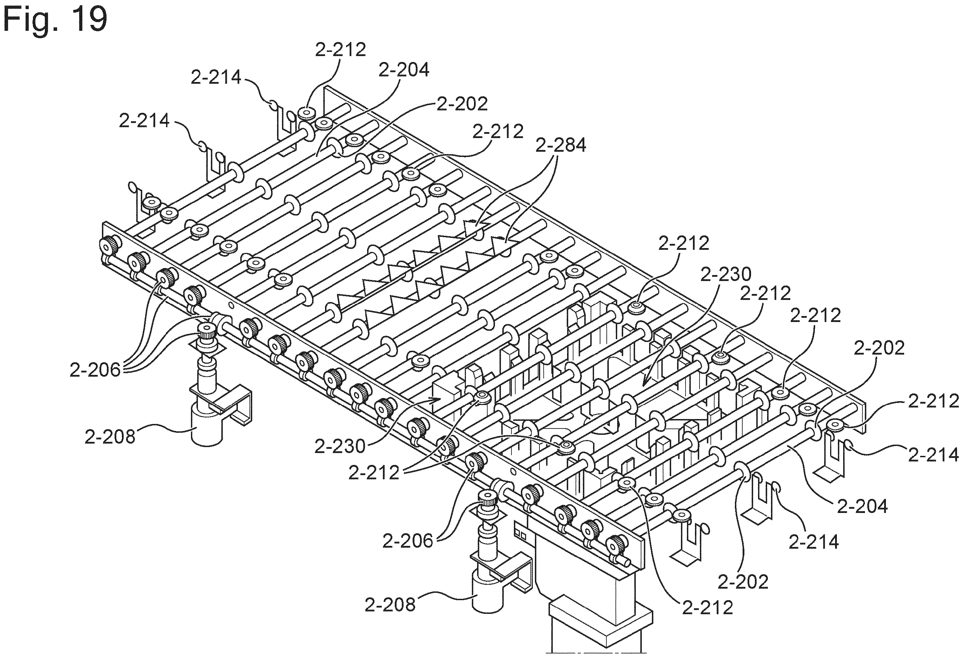

Fig. 19 is a perspective view illustrating the transfer module 2-200 according to one embodiment. Note that, in Fig. 19, upper transfer rollers (second transfer rollers) 2-290 and its driving mechanism are omitted for clarification of illustration. The illustrated transfer module 2-200 includes the plurality of transfer rollers (first transfer rollers) 2-202 for transferring the substrate WF. Rotating the transfer rollers 2-202 ensures transferring the substrate WF on the transfer rollers 2-202 in a predetermined direction. The transfer rollers 2-202 of the transfer module 2-200 may be formed of conductive polymer or may be formed of polymer without conductive property. The transfer rollers 2-202 are mounted on the roller shafts (first roller shafts) 2-204, and are driven by a motor 2-208 via a gear 2-206. In one embodiment, the motor 2-208 can be a servo motor, the gear 2-206 can be a gear type or can also be a magnet gear. The illustrated transfer module 2-200 includes a guide roller 2-212 that supports a side surface of the substrate WF during transfer. The illustrated transfer module 2-200 has a sensor 2-216 for detecting presence/absence of the substrate WF at the predetermined position on the transfer rollers 2-202. The sensor 2-216 can be a sensor of any format, and, for example, can be an optical sensor. In the embodiment illustrated in Fig. 18, seven sensors 2-216 (2-216a to 2-216g) are provided in the transfer module 2-200. In one embodiment, the operation of the transfer module 2-200 can be controlled according to the detection of the substrate WF by these sensors 2-216a to 2-216g. As illustrated in Fig. 18, the transfer module 2-200 has an inlet shutter 2-218 openable/closable for receiving the substrate WF in the transfer module 2-200. As illustrated in Fig. 18, in an area where the gripping or releasing of the substrate WF by the pusher 2-230 is not performed, upper transfer rollers 2-290 are arranged above the transfer rollers 2-202. The upper transfer rollers 2-290 are connected to a power source and are configured to be rotatable. In one embodiment, the upper transfer rollers 2-290 are configured to be driven by the gear 2-206 and the motor 2-208 similarly to the transfer rollers 2-202.

As illustrated in Fig. 18, the transfer module 2-200 has a stopper 2-220. The stopper 2-220 is connected to a stopper moving mechanism 2-222, and the stopper 2-220 is allowed to enter into a transfer path of the substrate WF moving on the transfer rollers 2-202. When the stopper 2-220 is positioned in the transfer path of the substrate WF, the side surface of the substrate WF moving on the transfer rollers 2-202 comes into contact with the stopper 2-220, and the substrate WF on the move can be stopped at the position of the stopper 2-220. When the stopper 2-220 is at the position evacuated from the transfer path of the substrate WF, the substrate WF can be moved on the transfer rollers 2-202. The stop position of the substrate WF by the stopper 2-220 is a position where the pusher 2-230, described below, can receive the substrate WF on the transfer rollers 2-202 (a substrate gripping or releasing position).

The sensor 2-216a is provided at an inlet side of the transfer module 2-200. When the sensor 2-216a confirms that a back of the substrate WF has passed, the inlet shutter 2-218 can be closed. Then, while monitoring the position of the substrate WF by the sensor 2-216b arranged at a downstream of the sensor 2-216a, the transfer rollers 2-202 transfer the substrate WF. At this time, the stopper 2-220 is moved inside the transfer path of the substrate WF by the stopper moving mechanism 2-222. The substrate WF transferred on the transfer rollers 2-202 comes into contact with the stopper 2-220, and the substrate WF is stopped. The sensor 2-216c is arranged at the position of the stopper 2-220, and the operation of the transfer rollers 2-202 is stopped when the substrate WF is detected by the sensor 2-216c. The substrate WF stopped at the position of the stopper 2-220 (the substrate gripping or releasing position) is gripped or released to the top ring 2-302 via the pusher 2-230.

The transfer module 2-200 illustrated in Figs. 18 and 19 has cleaning nozzles 2-284. The cleaning nozzles 2-284 have upper cleaning nozzles 2-284a arranged above the transfer rollers 2-202 and lower cleaning nozzles 2-284b arranged below the transfer rollers 2-202. The upper cleaning nozzles 2-284a and the lower cleaning nozzles 2-284b are connected to a supply source of a cleaning liquid, which is not illustrated. The upper cleaning nozzles 2-284a are configured to supply the cleaning liquid to a back surface of the substrate WF transferred on the transfer rollers 2-202. The lower cleaning nozzles 2-284b are configured to supply the cleaning liquid to a surface to be polished of the substrate WF transferred on the transfer rollers 2-202. The upper cleaning nozzles 2-284a and the lower cleaning nozzles 2-284b have widths approximately the same as a width of the substrate WF transferred on the transfer rollers 2-202 or equal to or larger than that, and are configured to clean the whole surface of the substrate WF as the substrate WF is transferred on the transfer rollers 2-202.

### <Pusher>

As illustrated in Figs. 18 and 19, the transfer module 2-200 has the pusher 2-230. The pusher 2-230 is configured to lift the substrate WF on the plurality of transfer rollers 2-202 to be able to grip or release it to the top ring 2-302. Also, the pusher 2-230 is configured to be able to grip or release the substrate WF received from the top ring 2-302 to the transfer rollers 2-202 of the transfer module 2-200.

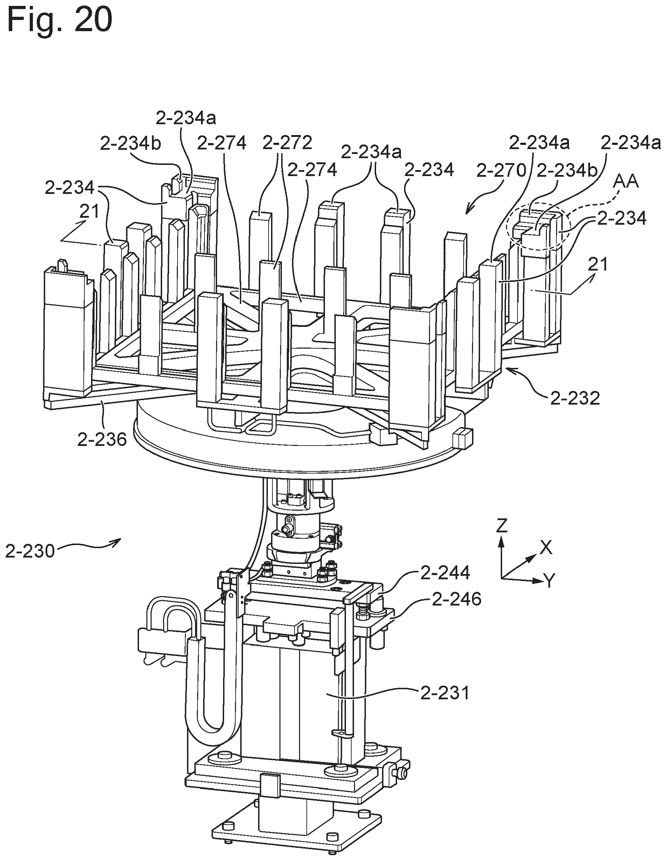

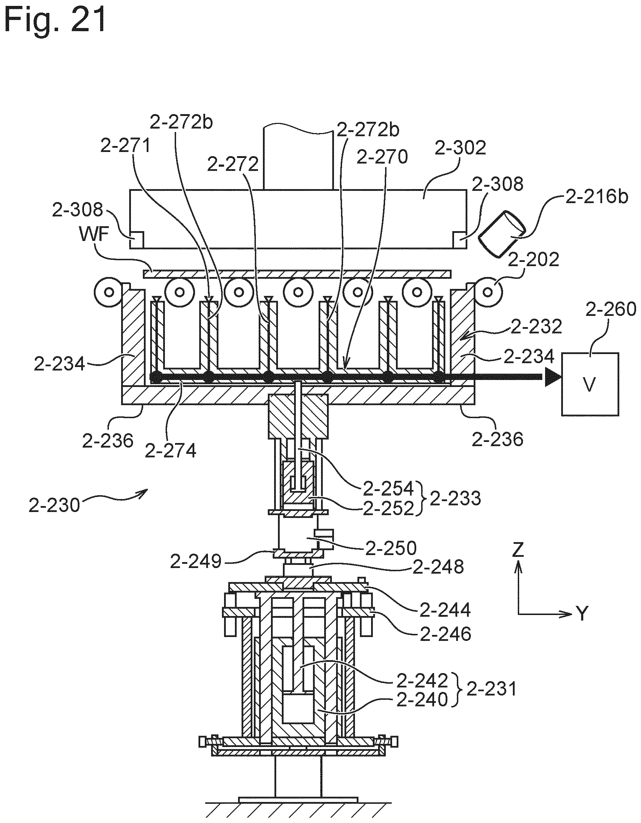

Fig. 20 is a perspective view illustrating the pusher 2-230 according to one embodiment. Fig. 21 is a partial cross-sectional view viewing the pusher 2-230 illustrated in Fig. 20 in a direction of an arrow 21. Fig. 21 schematically illustrates the transfer rollers 2-202, the substrate WF disposed at the substrate gripping or releasing position on the transfer rollers 2-202, and the top ring 2-302 that receives the substrate WF, together with the pusher 2-230. Note that, in Figs. 20 and 21, a wedge mechanism and an inclination mechanism, which will be described later, are omitted for clarification of illustration.

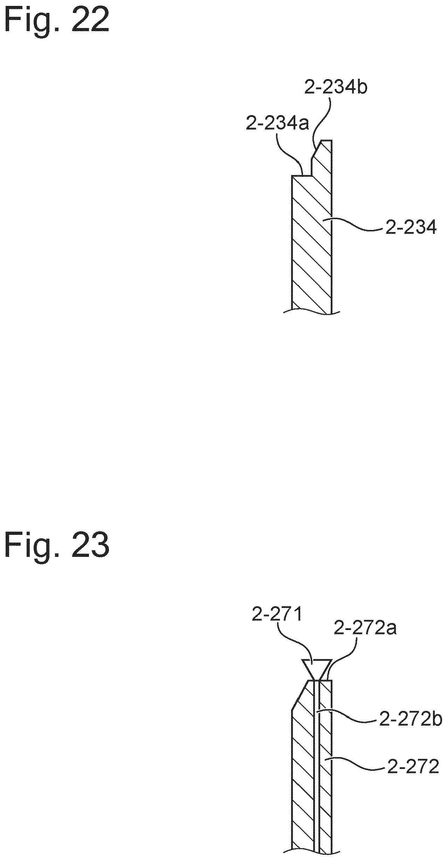

In the embodiment illustrated in Figs. 20 and 21, the pusher 2-230 includes a first stage 2-270 and a second stage 2-232. The second stage 2-232 is a stage for supporting the retainer member 2-308 of the top ring 2-302 when the substrate WF is gripped or released from the pusher 2-230 to the top ring 2-302. The second stage 2-232 includes a plurality of support pillars (second support pillars) 2-234. Fig. 22 is a cross-sectional view illustrating one of the support pillars of the second stage 2-232 according to one embodiment. As illustrated in Fig. 22, the support pillar 2-234 has one end having a flat support surface 2-234a that supports the retainer member 2-308 of the top ring 2-302 and an inclined surface 2-234b for guiding the top ring 2-302 when the substrate WF is gripped or released to the top ring 2-302 and when the substrate WF is received from the top ring 2-302. In one embodiment, the support pillars 2-234 at four corners among the plurality of support pillars 2-234 may have the support surfaces 2-234a and the inclined surfaces 2-234b as illustrated in Fig. 22. The support pillars 2-234 at the four corners form depressed portions, which ensure positioning the retainer member 2-308. The support pillars 2-234 other than ones at the four corners may have only the support surfaces 2-234a. The other ends of the respective support pillars 2-234 are coupled to a common base (second base) 2-236. Each of the support pillars 2-234 is provided at a position that does not interfere with the transfer rollers 2-202, and in the embodiment illustrated in Fig. 21, each of the support pillars 2-234 is arranged between the transfer rollers 2-202.

The first stage 2-270 is configured to receive the substrate WF on the transfer rollers 2-202. The first stage 2-270 includes a plurality of support pillars (first support pillars) 2-272. Fig. 23 is a cross-sectional view illustrating one of the support pillars 2-272 of the first stage 2-270 according to one embodiment. As illustrated in Fig. 23, the support pillar 2-272 has one end having a flat support surface 2-272a that supports the substrate WF when the substrate WF is gripped or released to the top ring 2-302 and when the substrate WF is received from the top ring 2-302. The support surface 2-272a is provided with a suction pad 2-271 having elasticity. The support surface 2-272a supports the substrate WF via the suction pad 2-271. Note that the suction pad 2-271 is not necessarily provided. At least one of the plurality of support pillars 2-272 is formed with a suction passage 2-272b that opens to the support surface 2-272a. The suction passage 2-272b communicates with a vacuum source 2-260. In view of this, at least one of the plurality of support pillars 2-272 is configured to be able to suction the substrate WF via the suction passage 2-272b when receiving the substrate WF from the top ring 2-302. The other ends of the respective support pillars 2-272 are coupled to a common base (first base) 2-274. Each of the support pillars 2-272 is provided at a position that does not interfere with the transfer rollers 2-202, and in the embodiment illustrated in Fig. 21, each of the support pillars 2-272 is arranged between the transfer rollers 2-202. Also, each of the support pillars 2-272 is arranged to support areas without a pattern, such as a circuit on the surface to be polished of the substrate WF. The first stage 2-270 and the second stage 2-232 are, as will be described in detail below, coupled to respective elevating mechanisms, and are respectively movable in the height direction (z-direction).

The second stage 2-232 is configured to be movable in the height direction (z-direction). In one embodiment, the pusher 2-230 has a second elevating mechanism 2-231. In one embodiment, as illustrated in Figs. 20 and 21, the second elevating mechanism 2-231 of the pusher 2-230 is an elevating mechanism of a pneumatic pressure type, and includes a cylinder (third cylinder) 2-240 and a piston (third piston) 2-242. The piston 2-242 has an end coupled to a movable pedestal 2-244. The cylinder 2-240 is coupled to a fixed pedestal 2-246. The fixed pedestal 2-246 is fixed, for example, to a housing 2-201 covering the whole transfer module 2-200 or a floor surface on which the transfer module 2-200 is installed. Adjusting an air pressure inside the cylinder 2-240 ensures moving the piston 2-242 to move the movable pedestal 2-244 in the height direction (z-direction). The movement of the movable pedestal 2-244 in the height direction ensures moving the first stage 2-270 and the second stage 2-232 in the height direction. In the illustrated embodiment, an XY-stage 2-248 that can move the first stage 2-270 and the second stage 2-232 within a horizontal plane is mounted on the movable pedestal 2-244. The XY-stage 2-248 can be a known XY-stage configured to be movable in two perpendicular directions by a linear motion guide or the like. In the illustrated embodiment, a rotary stage 2-250 is mounted on the XY-stage 2-248. The rotary stage 2-250 is configured to be rotatable on an XY-plane (horizontal plane). In other words, the rotary stage 2-250 is configured to be rotatable about a z-axis. For the rotary stage 2-250, a known rotary stage 2-250 configured of, for example, a rotational bearing can be employed.

On the rotary stage 2-250, a first elevating mechanism 2-233 is mounted. The first elevating mechanism 2-233 has a cylinder (first cylinder) 2-252 and a piston (first piston) 2-254. The cylinder 2-252 is coupled to the base 2-236 of the second stage 2-232. Also, a movable piston 2-254 is coupled to the cylinder 2-252, and adjusting an air pressure inside the cylinder 2-252 ensures moving the piston 2-254. The piston 2-254 has an end coupled to the base 2-274 of the first stage 2-270. Therefore, adjusting an air pressure inside the cylinder 2-252 ensures moving the piston 2-254 and the first stage 2-270 in the height direction (z-direction). In view of this, the first elevating mechanism 2-233 can be configured to raise the base 2-274 to bring the support surface 2-272a into contact with the substrate WF via the suction pad 2-271, and move the base 2-274 down in a state where the substrate WF is suctioned via the suction passage 2-272b when the substrate WF is received from the top ring 2-302. Furthermore, the sensor 2-216b can be configured to detect the presence/absence of the substrate WF on the support surface 2-272a. In this case, the first elevating mechanism 2-233 can be configured to repeat moving the base 2-274 up and down in the case where the sensor 2-216b detects that there is no substrate WF in the state where the base 2-274 is moved down when receiving the substrate WF from the top ring 2-302. That is, in the case where the substrate WF is not normally received from the top ring 2-302, the first elevating mechanism 2-233 can raise the base 2-274 to bring the support surface 2-272a into contact with the substrate WF and move the base 2-274 down in a state where the substrate WF is suctioned via the suction passage 2-272b, again.

With the above-described configuration, the second elevating mechanism 2-231 can move both the first stage 2-270 and the second stage 2-232 in the height direction (z-direction), and the first elevating mechanism 2-233 can move the first stage 2-270 in the height direction (z-direction) with respect to the second stage 2-232. The first stage 2-270 and the second stage 2-232 are movable in the two perpendicular directions (xy-directions) within the horizontal plane by the XY-stage 2-248. Furthermore, the first stage 2-270 and the second stage 2-232 are rotatable within the horizontal plane (about the z-axis) by the rotary stage 2-250. Therefore, when the substrate WF is transmitted and received between the pusher 2-230 and the top ring 2-302, the pusher 2-230 and the top ring 2-302 can be positioned. Note that, while in the illustrated embodiment, the first elevating mechanism 2-233 and the second elevating mechanism 2-231 are elevating mechanisms of a pneumatic pressure type, these elevating mechanisms may be of a fluid pressure type or may be elevating mechanisms of an electrically operated type using, for example, a motor and a ball screw. The second elevating mechanism 2-231 ensures moving the second stage 2-232 and the first stage 2-270 between a lower position and an upper position.

Next, a description will be given of the gripping or releasing of the substrate WF from the pusher 2-230 to the top ring 2-302. Fig. 21 illustrates a state where the first stage 2-270 and the second stage 2-232 are at the lower positions. When the substrate WF is gripped or released to the top ring 2-302, the pusher 2-230 raises the first stage 2-270 and the second stage 2-232 with the second elevating mechanism 2-231 from the state illustrated in Fig. 21. In view of this, the pusher 2-230 brings the suction pad 2-271 into contact with the substrate WF to lift the substrate WF, and supports the retainer member 2-308 of the top ring 2-302 with the support surfaces 2-234a of the support pillars 2-234. Subsequently, the pusher 2-230 raises the first stage 2-270 with respect to the second stage 2-232 with the first elevating mechanism 2-233, thereby bringing the substrate WF into contact with the top ring 2-302. Vacuum drawing from the pressure chamber P1 of the top ring 2-302 in this state causes the top ring 2-302 to suction the substrate WF, and the substrate WF is gripped or released to the top ring 2-302. The substrate WF gripped or released to the top ring 2-302 undergoes a polishing process by the polishing module 2-300. After the gripping or releasing of the substrate WF to the top ring 2-302, the pusher 2-230 returns to the state illustrated in Fig. 21. Note that the vacuum drawing by the vacuum source 2-260 is stopped when the substrate WF is gripped or released to the top ring 2-302.

Next, a description will be given of the gripping or releasing of the substrate WF from the top ring 2-302 to the pusher 2-230. When receiving the substrate WF from the top ring 2-302, the pusher 2-230 raises the first stage 2-270 and the second stage 2-232 with the second elevating mechanism 2-231 from the state illustrated in Fig. 21, and supports the retainer member 2-308 of the top ring 2-302 with the support surfaces 2-234a of the support pillars 2-234. Subsequently, the pusher 2-230 raises the first stage 2-270 with respect to the second stage 2-232 with the first elevating mechanism 2-233, thereby bringing the suction pad 2-271 into contact with the substrate WF. Subsequently, the pusher 2-230 suctions the substrate WF via the suction pad 2-271 by starting the vacuum drawing with the vacuum source 2-260. On the other hand, the top ring 2-302 stops the vacuum drawing from the pressure chamber PI, and supplies a pressurized fluid, such as pressurized air, to the pressure chamber P1 via the fluid path 2-312. It is conceivable to peel the substrate WF off of the top ring 2-302 by lowering the pusher 2-230 in this state. However, when the surface tension between the substrate WF and the top ring 2-302 is strongly affecting, there could be a problem that the substrate WF cannot be peeled off of the top ring 2-302 even though the pusher 2-230 is moved down.

### <Wedge Mechanism>

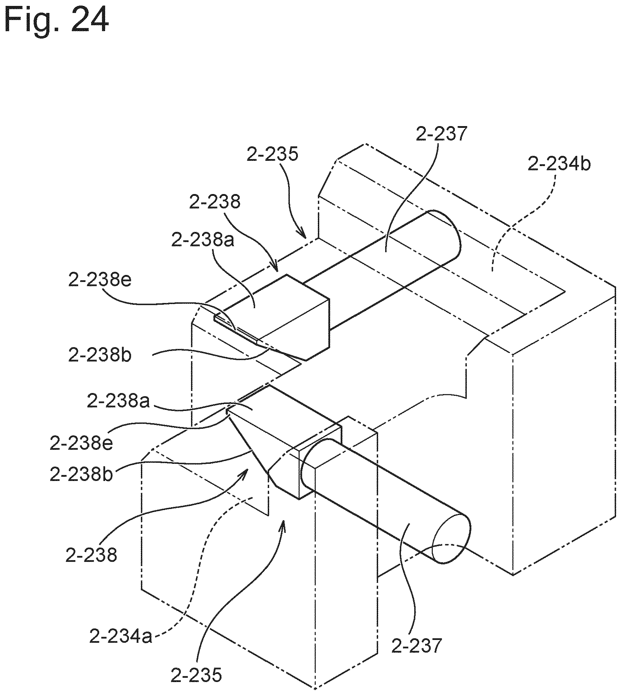

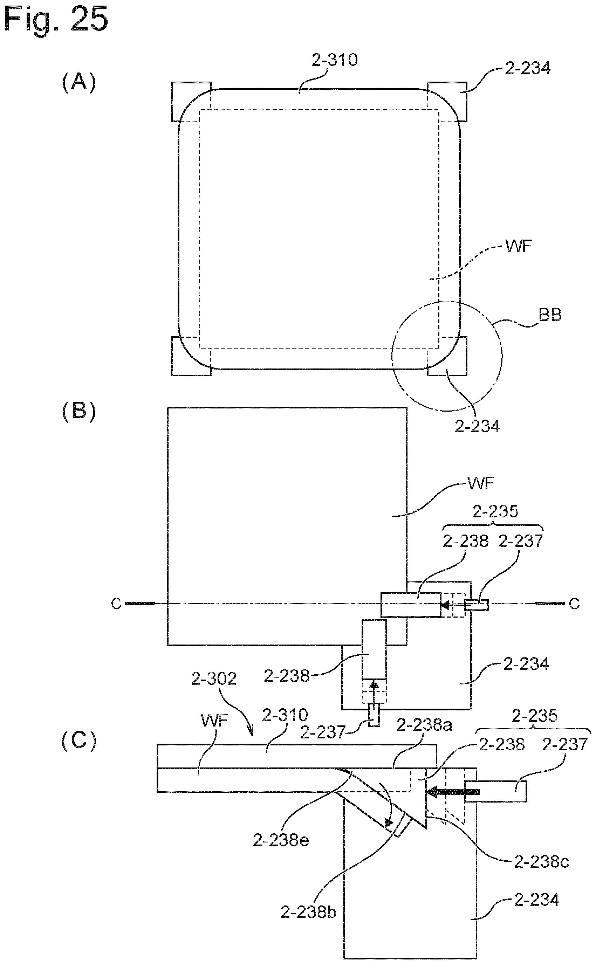

In contrast to this, in this embodiment, the wedge mechanism is employed for improving reliability of the gripping or releasing of the substrate WF from the top ring 2-302 to the pusher 2-230. Fig. 24 is a perspective view schematically illustrating the wedge mechanism according to one embodiment. Fig. 24 schematically illustrates the wedge mechanism by enlarging an AA region in Fig. 20. Figs. 25(A) to 25(C) are plan views and a cross-sectional view schematically illustrating the wedge mechanism according to one embodiment. Fig. 25(A) is a plan view schematically illustrating the wedge mechanism, Fig. 25(B) illustrates an enlarged BB region in Fig. 25(A), and Fig. 25(C) illustrates the cross-sectional view at a C-C cross-sectional surface in Fig. 25(B).

As illustrated in Figs. 24 and 25, the substrate processing apparatus in the embodiment includes two wedge mechanisms 2-235 provided in the support pillar 2-234. The two wedge mechanisms 2-235 are arranged so as to sandwich a corner of the substrate WF in a rectangular shape. Since the two wedge mechanisms 2-235 has an identical configuration, only one wedge mechanism 2-235 is described below as a representative. Note that, while in this embodiment, an example in which the two wedge mechanisms 2-235 are provided in one out of four support pillars 2-234 is illustrated, the embodiment is not limited to this, and the wedge mechanism 2-235 may be provided in a plurality of support pillars 2-234. Also, the wedge mechanism 2-235 may be provided in a member other than the support pillars 2-234.

The wedge mechanism 2-235 includes a wedge member 2-238 inserted between the substrate WF and the top ring 2-302. The wedge member 2-238 is arranged at a side of the substrate WF held onto the elastic pad 2-310 of the top ring 2-302 when the substrate WF is gripped or released from the top ring 2-302 to the pusher 2-230. The wedge member 2-238 has a wedge shape insertable between the substrate WF and the top ring 2-302. Specifically, the wedge member 2-238 has a first surface 2-238a extending parallel to the back surface of the substrate WF and a second surface 2-238b opposed to the first surface 2-238a and inclining so as to be tapered off toward the direction to the substrate WF. The first surface 2-238a and the second surface 2-238b have ends in a substrate WF side that are connected, and the first surface 2-238a and the second surface 2-238b form a leading end 2-238e having an acute angle. The wedge member 2-238 has a third surface 2-238c connecting ends of the first surface 2-238a and the second surface 2-238b in an opposite side of the substrate WF. In this embodiment, the wedge member 2-238 is positioned in the support pillar 2-234 such that the leading end 2-238e having the acute angle of the wedge member 2-238 is arranged in a side of a contact surface between the elastic pad 2-310 and the back surface of the substrate WF with the support surfaces 2-234a of the support pillars 2-234 supporting the retainer member 2-308 of the top ring 2-302.

The wedge mechanism 2-235 includes a driving member 2-237 configured to move the wedge member 2-238 in a direction along the back surface of the substrate WF so as to insert the wedge member 2-238 between the back surface of the substrate WF and the elastic pad 2-310 of the top ring 2-302. The driving member 2-237 is, in one example, a driving mechanism of a pneumatic pressure type including a piston connected to the wedge member 2-238 and a cylinder housing the piston, and can move the wedge member 2-238 back and forth in a direction along the back surface of the substrate WF via the piston by adjusting the air pressure inside the cylinder. However, not limited to this, a known mechanism can be employed for the driving member 2-237.

The wedge mechanism 2-235 inserts the wedge member 2-238 between the back surface of the substrate WF and the elastic pad 2-310 of the top ring 2-302 as illustrated in Fig. 25(C) when the substrate WF is gripped or released from the top ring 2-302 to the pusher 2-230. This ensures peeling the end of the substrate WF off of the elastic pad 2-310 against the surface tension affecting between the substrate WF and the top ring 2-302. Peeling the end of the substrate WF off of the elastic pad 2-310 makes the surrounding gas (air) easy to get in between the substrate WF and the top ring 2-302. Accordingly, the pusher 2-230 can easily peel the whole substrate WF off of the elastic pad 2-310 by lowering the first stage 2-270 with the substrate WF being suctioned via the suction pad 2-271. The substrate processing apparatus of the embodiment ensures improving reliability of the gripping or releasing of the substrate WF from the top ring 2-302 to the pusher 2-230.

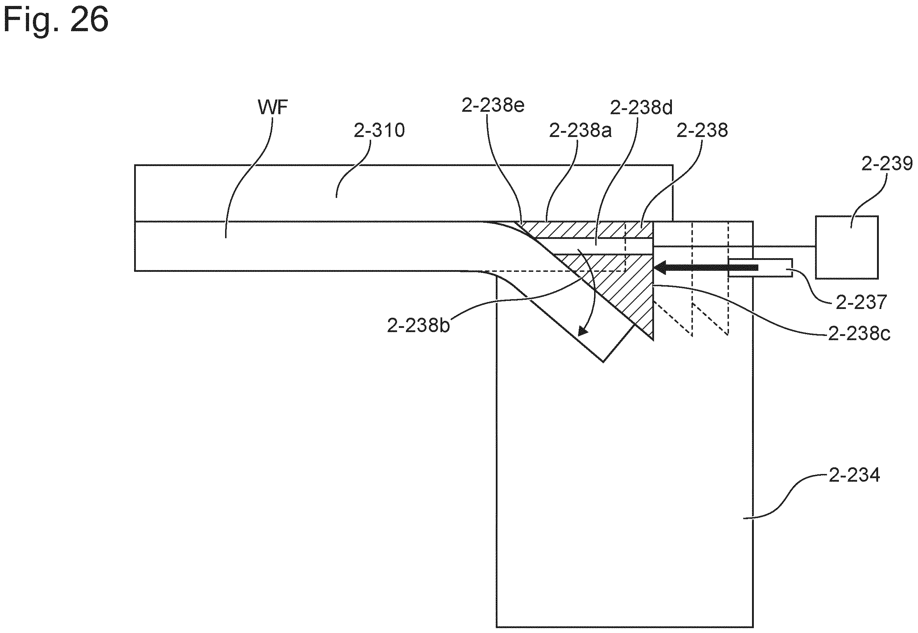

Fig. 26 is a cross-sectional view schematically illustrating a wedge mechanism in a modification. As illustrated in Fig. 26, the wedge member 2-238 in the modification has a hole 2-238d that internally passes through the wedge member 2-238 and opens to the second surface 2-238b. While in this embodiment, the hole 2-238d is formed to communicate between the second surface 2-238b and the third surface 2-238c of the wedge member 2-238, it is not limited to this. The wedge mechanism 2-235 includes a fluid supply source 2-239 that can inject a fluid (for example, a gas, such as air or nitrogen) from the second surface 2-238b via the hole 2-238d.

The wedge mechanism 2-235 in the modification inserts the wedge member 2-238 between the back surface of the substrate WF and the elastic pad 2-310 of the top ring 2-302 similarly to the above when the substrate WF is gripped or released from the top ring 2-302 to the pusher 2-230. Subsequently, the wedge mechanism 2-235 injects the fluid from the second surface 2-238b via the hole 2-238d with the fluid supply source 2-239. The modification inserts the wedge member 2-238 between the back surface of the substrate WF and the elastic pad 2-310 of the top ring 2-302 to form a clearance between the end of the substrate WF and the elastic pad 2-310, and injects the fluid from the second surface 2-238b to the clearance, thereby ensuring easily peeling the whole substrate WF off of the elastic pad 2-310. Accordingly, the pusher 2-230 can easily peel the whole substrate WF off of the elastic pad 2-310 by lowering the first stage 2-270 with the substrate WF being suctioned via the suction pad 2-271. The substrate processing apparatus of the modification ensures improving reliability of the gripping or releasing of the substrate WF from the top ring 2-302 to the pusher 2-230. Note that the substrate processing apparatus 2-1000 ensures supplying the pressurized fluid, such as the pressurized air, to the pressure chamber (air bag) P1 when the substrate WF is gripped or released from the top ring 2-302 to the pusher 2-230 as described above. In view of this, the elastic pad 2-310 expands to curve the lower surface of the elastic pad 2-310 to downwardly project, and therefore, the clearance with which the wedge member 2-238 is easily inserted can be made between the elastic pad 2-310 and the back surface of the outer peripheral portion of the substrate WF. In addition to this, a plurality of openings, which are not illustrated, communicating between the pressure chamber P1 and a substrate holding surface of the elastic pad 2-310 supply a pressurized fluid, such as pressurized air, toward the back surface of the substrate WF. As a result, the substrate WF can be easily peeled off of the elastic pad 2-310, thereby ensuring improving reliability and promptness of the gripping or releasing of the substrate WF from the top ring 2-302 to the pusher 2-230. Improving the promptness of the gripping or releasing of the substrate WF from the top ring 2-302 to the pusher 2-230 reduces the transferring period of the substrate WF, thereby ensuring improved throughput of the substrate processing apparatus 2-1000.

### inclination Mechanism>

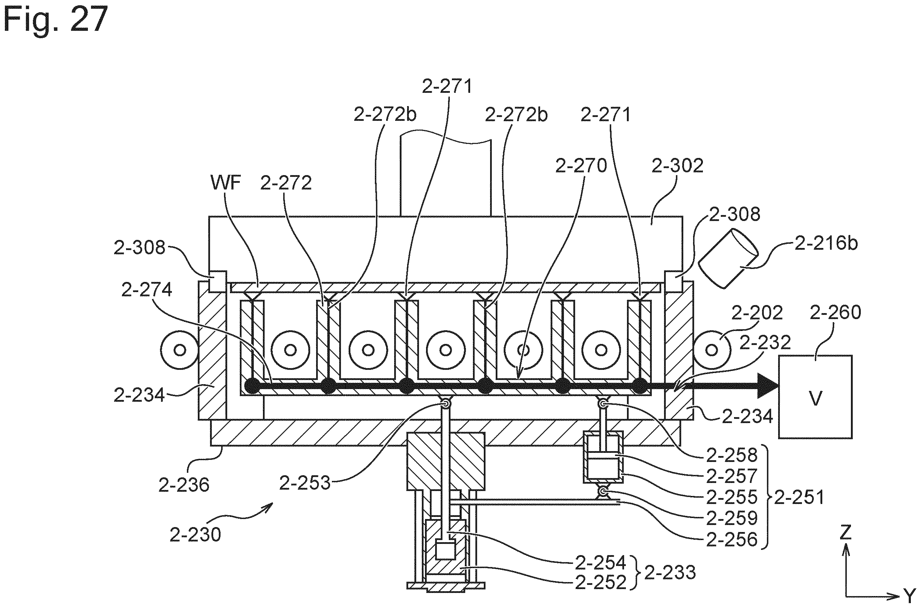

Next, a description will be given of the inclination mechanism for inclining the first stage 2-270 of the pusher 2-230. Fig. 27 to Fig. 30 are cross-sectional views schematically illustrating the inclination mechanism according to one embodiment. In Fig. 27 to Fig. 30, the second elevating mechanism 2-231 and the wedge mechanism 2-235 are omitted for clarification of illustration. Fig. 27 illustrates a state where the first stage 2-270 and the second stage 2-232 are raised with the second elevating mechanism 2-231 from the state illustrated in Fig. 21, and furthermore, the first stage 2-270 is raised with respect to the second stage 2-232 with the first elevating mechanism 2-233, and the suction pad 2-271 is brought into contact with the substrate WF.

As illustrated in Fig. 27, the substrate processing apparatus in the embodiment includes an inclination mechanism 2-251 for inclining the first stage 2-270. The inclination mechanism 2-251 includes a first rotation shaft 2-253 mounted in the center of a bottom surface of the first stage 2-270. The first rotation shaft 2-253 is provided between the piston 2-254 and the first stage 2-270. In other words, the piston 2-254 supports the first stage 2-270 via the first rotation shaft 2-253. The inclination mechanism 2-251 includes a shaft 2-256 extending to a side from the piston 2-254, a second rotation shaft 2-258 mounted at an end of the bottom surface of the first stage 2-270, and a piston (second piston) 2-257 that supports the first stage 2-270 via the second rotation shaft 2-258. The inclination mechanism 2-251 includes a third rotation shaft 2-259 mounted on an upper surface of the shaft 2-256 and a cylinder (second cylinder) 2-255 configured to move the piston 2-257 up and down. The cylinder 2-255 is supported by the shaft 2-256 via the third rotation shaft 2-259. While the first rotation shaft 2-253, the second rotation shaft 2-258, and the third rotation shaft 2-259 are rotation shafts in hinge shapes extending in a direction of the x-axis in the embodiment, they are not limited to this. The first rotation shaft 2-253, the second rotation shaft 2-258, the third rotation shaft 2-259, the piston 2-254, the shaft 2-256, the piston 2-257, and the cylinder 2-255 form a link mechanism, and it is configured that the first stage 2-270 can be inclined about the first rotation shaft 2-253 by the link mechanism. Note that, while in the embodiment, the example in which the first rotation shaft 2-253 is provided in the center of the bottom surface of the first stage 2-270 and the second rotation shaft 2-258 is mounted at the end of the bottom surface of the first stage 2-270 has been described, the example is not limited to this, but the first rotation shaft 2-253 and the second rotation shaft 2-258 are installed at any position.

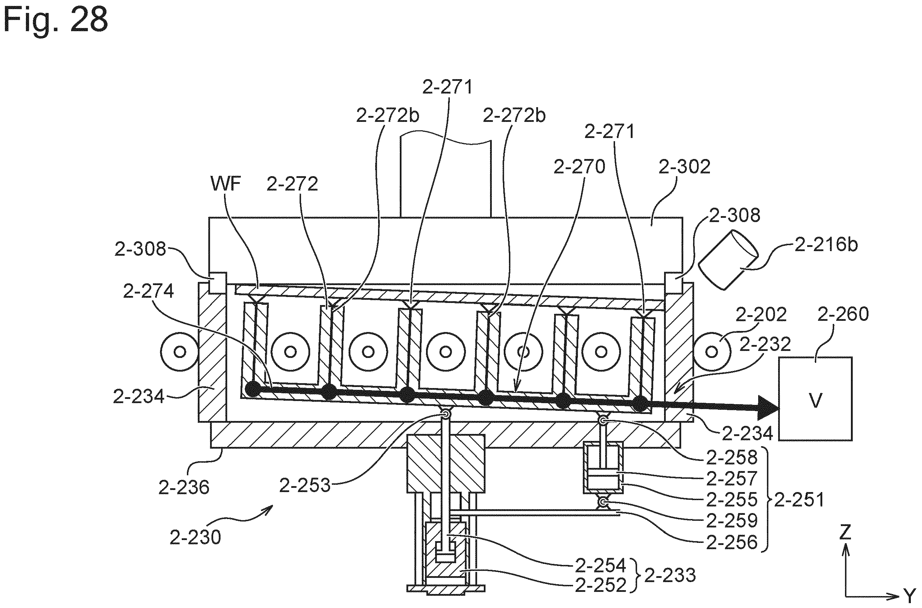

Fig. 28 illustrates a state where the end of the substrate WF is peeled off from the state illustrated in Fig. 27. As illustrated in Fig. 28, the pusher 2-230 is configured to peel the end of the substrate WF off of the top ring 2-302 by inclining the first stage 2-270 using the inclination mechanism 2-251 when the substrate WF is gripped or released from the top ring 2-302 to the pusher 2-230. Specifically, the pusher 2-230 inserts the wedge member 2-238 between the substrate WF and the top ring 2-302 using the wedge mechanism 2-235. Subsequently, the pusher 2-230, while lowering the whole first stage 2-270 by lowering the piston 2-254, rotates (inclines) the first stage 2-270 in a clockwise direction about the first rotation shaft 2-253 by lowering the piston 2-257. With the embodiment, the clearance is formed between the end of the substrate WF and the top ring 2-302 by inserting the wedge member 2-238. In addition to this, a gas easily gets into the whole substrate WF from the clearance by inclining the first stage 2-270 so as to peel off the end of the substrate WF where the clearance is formed, thereby ensuring easily peeling the substrate WF off of the top ring 2-302 with a small force.

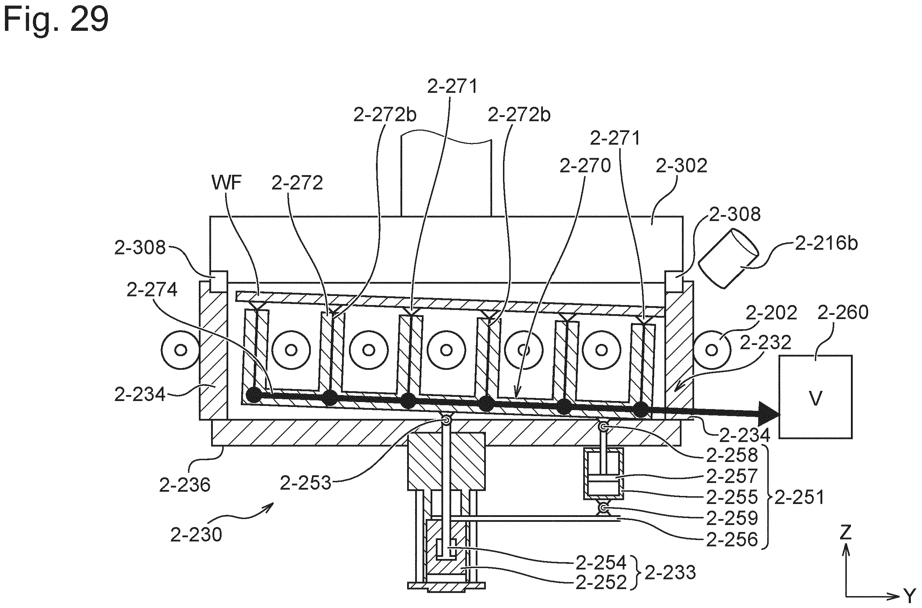

Fig. 29 illustrates a state where the first stage 2-270 is moved down using the first elevating mechanism 2-233 after peeling the end of the substrate WF off of the top ring 2-302 as illustrated in Fig. 28. As illustrated in Fig. 29, the pusher 2-230 can lower the first stage 2-270 while being inclined by lowering the piston 2-254. This ensures peeling the whole substrate WF off of the top ring 2-302 as illustrated in Fig. 29. Note that the pusher 2-230 can inject the fluid from the second surface 2-238b via the hole 2-238d with the fluid supply source 2-239 at any timing in the process of peeling the substrate WF off of the top ring 2-302 using the inclination mechanism 2-251 and the first elevating mechanism 2-233 after inserting the wedge member 2-238 between the substrate WF and the top ring 2-302. This injects the fluid between the top ring 2-302 and the substrate WF to weaken the surface tension between the two, thereby ensuring even more improved reliability of the gripping or releasing of the substrate WF from the top ring 2-302 to the pusher 2-230.

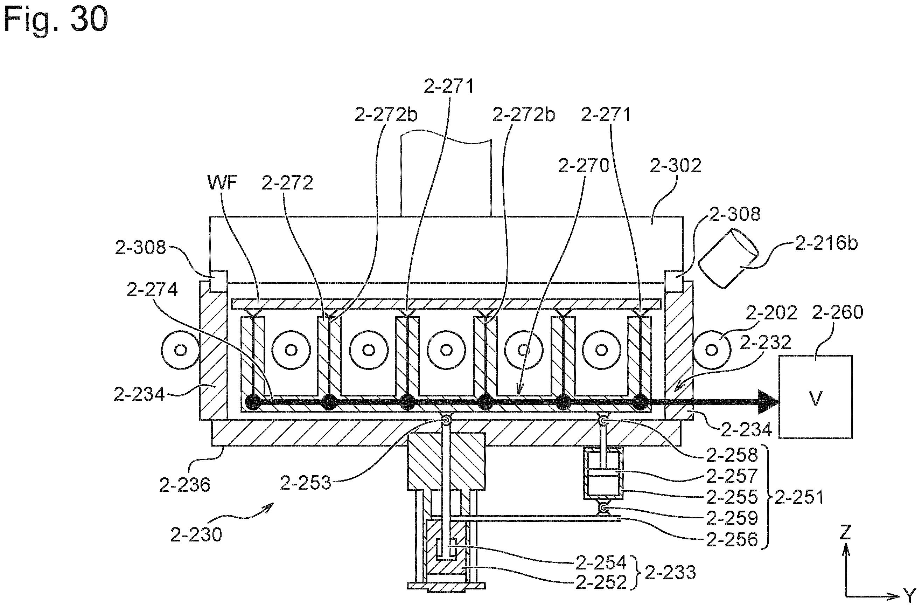

Fig. 30 illustrates a state where the first stage 2-270 is horizontalized from the state illustrated in Fig. 29 using the inclination mechanism 2-251. As illustrated in Fig. 30, the pusher 2-230 rotates the first stage 2-270 in an anti-clockwise direction about the first rotation shaft 2-253 by moving the piston 2-257 up to ensure returning the first stage 2-270 and the substrate WF to a horizontal state. The pusher 2-230 can grip or release the substrate WF onto the transfer rollers 2-202 by lowering the first stage 2-270 and the second stage 2-232 with the second elevating mechanism 2-231 after the state in Fig. 30 is obtained.

In the foregoing, several embodiments of the present invention have been described above in order to facilitate understanding of the present invention without limiting the present invention. The present invention can be changed or improved without departing from the gist thereof, and of course, the equivalents of the present invention are included in the present invention. It is possible to arbitrarily combine or omit respective components described in the claims and specification in a range in which at least a part of the above-described problems can be solved, or a range in which at least a part of the effects can be exhibited.

From the above-described embodiments, at least the following technical ideas are obtained.

### [Configuration 1]

According to a configuration 1, a pusher is provided. The pusher includes: a plurality of first support pillars having one ends and support surfaces for supporting a substrate on the one ends; a first base coupled to other ends of the plurality of first support pillars; and a first elevating mechanism configured to move the first base up and down. The support surface is configured to support the substrate when the substrate is gripped or released to a top ring and when the substrate is received from the top ring, and at least one of the plurality of first support pillars include a suction passage communicating with a vacuum source and opening to the support surface.

### [Configuration 2]

According to a configuration 2, at least one of the plurality of first support pillars is configured to suction the substrate via the suction passage when the substrate is received from the top ring.

### [Configuration 3]

According to a configuration 3, the first elevating mechanism is configured to bring the support surface into contact with the substrate by raising the first base and move the first base down while the substrate is suctioned via the suction passage when the substrate is received from the top ring.

### [Configuration 4]

According to a configuration 4, the pusher further includes a sensor for detecting presence/absence of a substrate on the support surface. The first elevating mechanism is configured to repeat moving the first base up and down in a case where the sensor detects that there is no substrate in a state where the first base is moved down when the substrate is received from the top ring.

### [Configuration 5]

According to a configuration 5, the pusher further includes a plurality of second support pillars having one ends and support surfaces for supporting the top ring when the substrate is gripped or released to the top ring and when the substrate is received from the top ring on the one ends; a second base coupled to other ends of the plurality of second support pillars; and a second elevating mechanism configured to move the first base and the second base up and down.

### [Configuration 6]

According to a configuration 6, a substrate transfer apparatus for transferring a substrate is provided. The substrate transfer apparatus includes: a plurality of first transfer rollers configured to support a lower surface of a substrate; a plurality of first roller shafts to which the plurality of transfer rollers are mounted; a motor for rotating the plurality of first roller shafts; and any one of the above-described pushers for lifting the substrate on the plurality of first transfer rollers to grip or release the substrate to the top ring and placing the substrate received from the top ring on the plurality of first transfer rollers. The pusher is arranged such that the plurality of first support pillars pass through clearances between the plurality of first roller shafts.

### [Configuration 7]

According to a configuration 7, the pusher is arranged such that the plurality of first support pillars and the plurality of second support pillars pass through the clearances between the plurality of first roller shafts.

### [Configuration 8]

According to a configuration 8, the substrate transfer apparatus further includes: a plurality of second transfer rollers configured to support an upper surface of the substrate; and a plurality of second roller shafts to which the plurality of second transfer rollers are mounted. The motor is configured to rotate the second roller shaft along with the first roller shaft.

### [Configuration 9]

According to a configuration 9, the substrate transfer apparatus further includes: a thickness sensor configured to measure a thickness of the substrate; and a driving device configured to adjust an interval between the plurality of first transfer rollers and the plurality of second transfer rollers by moving at least one position of the plurality of first transfer rollers and the plurality of second transfer rollers corresponding to a measurement result by the thickness sensor.

### [Configuration 10]

According to a configuration 10, the substrate transfer apparatus further includes: an elastic member configured to bias the second transfer roller toward a direction to the first transfer roller.

### [Configuration 11]

According to a configuration 11, a substrate processing apparatus is provided. The substrate processing apparatus includes: a polishing module for polishing a substrate; a transfer module for transferring the substrate; and a drying module for drying the substrate. The transfer module includes the substrate transfer apparatus according to any one of the above-described substrate transfer apparatuses.

### [Configuration 12]

This application discloses a substrate processing apparatus as an embodiment. The substrate processing apparatus includes: a top ring configured to hold a back surface of a substrate with a surface to be polished facing downward; a pusher configured to grip or release the substrate between the pusher and the top ring; and a wedge mechanism including a wedge member arranged at a side of the substrate held onto the top ring when the substrate is gripped or released from the top ring to the pusher, and a driving member configured to move the wedge member in a direction along the back surface of the substrate to insert the wedge member between the back surface of the substrate and the top ring.

### [Configuration 13]

Additionally, this application discloses a substrate processing apparatus as an embodiment. In the substrate processing apparatus, the wedge member has a first surface extending parallel to the back surface of the substrate and a second surface opposed to the first surface and inclining to taper off toward a direction to the substrate.

### [Configuration 14]

Additionally, this application discloses a substrate processing apparatus as an embodiment. In the substrate processing apparatus, the wedge member has a hole internally passing through the wedge member to open to the second surface, and the wedge mechanism further includes a fluid supply source configured to inject a fluid from the second surface via the hole.

### [Configuration 15]

Additionally, this application discloses a substrate processing apparatus as an embodiment. In the substrate processing apparatus, the pusher includes a first stage for gripping or releasing the substrate between the pusher and the top ring, a first elevating mechanism for moving the first stage up and down, and an inclination mechanism for inclining the first stage.

### [Configuration 16]

Additionally, this application discloses a substrate processing apparatus as an embodiment. In the substrate processing apparatus, the pusher is configured to peel an end of the substrate off of the top ring by inclining the first stage using the inclination mechanism when the substrate is gripped or released from the top ring to the pusher.

### [Configuration 17]

Additionally, this application discloses a substrate processing apparatus as an embodiment. In the substrate processing apparatus, the pusher is configured to move the first stage down using the first elevating mechanism and horizontalize the first stage using the inclination mechanism after the end of the substrate is peeled off of the top ring.

### [Configuration 18]

Additionally, this application discloses a substrate processing apparatus as an embodiment. In the substrate processing apparatus, the first elevating mechanism includes a first piston supporting a bottom surface of the first stage and a first cylinder configured to move the first piston up and down, and the inclination mechanism includes a first rotation shaft provided between the first piston and the first stage, a shaft extending to a side from the first piston, a second rotation shaft mounted on a bottom surface of the first stage, a second piston supporting the first stage via the second rotation shaft, a third rotation shaft mounted on an upper surface of the shaft, and a second cylinder supported by the shaft via the third rotation shaft and configured to move the second piston up and down.

### [Configuration 19]

Additionally, this application discloses a substrate processing apparatus as an embodiment. In the substrate processing apparatus, the first stage includes a plurality of first support pillars having one ends and support surfaces for supporting the substrate via a suction pad on the one ends and a first base coupled to other ends of the plurality of first support pillars, and at least one of the plurality of first support pillars include a suction passage communicating with a vacuum source and opening to the support surface.

### [Configuration 20]

Additionally, this application discloses a substrate processing apparatus as an embodiment. The substrate processing apparatus further includes: a second stage for supporting the top ring when the substrate is gripped or released between the pusher and the top ring and a second elevating mechanism for moving the first stage and the second stage up and down. The second stage includes a plurality of second support pillars having one ends and support surfaces for supporting the top ring when the substrate is gripped or released between the pusher and the top ring on the one ends and a second base coupled to other ends of the plurality of second support pillars, and the wedge member is provided in at least one of the plurality of second support pillars.

### REFERENCE SIGNS LIST

- 200: transfer module
- 202: transfer roller (first transfer roller)
- 204: roller shaft (first roller shaft)
- 208: motor
- 209: motor
- 211: driving device
- 216: sensor
- 217: thickness sensor
- 230: pusher
- 231: second elevating mechanism
- 233: first elevating mechanism
- 234: support pillar (second support pillar)
- 234a: support surface
- 236: base (second base)
- 260: vacuum source
- 272: support pillar (first support pillar)
- 272a: support surface
- 272b: suction passage
- 274: base (first base)
- 290: upper transfer roller (second transfer roller)
- 291: upper roller shaft (second roller shaft)
- 296: elastic member
- 300: polishing module
- 302: top ring
- 500: drying module
- 1000: substrate processing apparatus
- 2-230: pusher
- 2-231: second elevating mechanism
- 2-232: second stage
- 2-233.: first elevating mechanism
- 2-234, 2-272: support pillar
- 2-234a, 2-272a: support surface
- 2-234b: inclined surface
- 2-235: wedge mechanism
- 2-236, 2-274: base
- 2-237: driving member
- 2-238: wedge member
- 2-238a: first surface
- 2-238b: second surface
- 2-238c: third surface
- 2-238d: hole
- 2-239: fluid supply source
- 2-240: cylinder
- 2-242, 2-254, 2-257: piston
- 2-251: inclination mechanism
- 2-252, 2-255: cylinder
- 2-253: first rotation shaft
- 2-256: shaft
- 2-258: second rotation shaft
- 2-259: third rotation shaft
- 2-260: vacuum source
- 2-270: first stage
- 2-271: suction pad
- 2-272b: suction passage
- 2-302: top ring
- 2-310: elastic pad
- 2-1000: substrate processing apparatus
- WF: substrate

## Claims

1. A pusher comprising:
a plurality of first support pillars having one ends and support surfaces for supporting a substrate on the one ends;
a first base coupled to other ends of the plurality of first support pillars; and
a first elevating mechanism configured to move the first base up and down, wherein
the support surface is configured to support the substrate when the substrate is gripped or released to a top ring and when the substrate is received from the top ring, and
at least one of the plurality of first support pillars include a suction passage communicating with a vacuum source and opening to the support surface.

2. The pusher according to claim 1, wherein
at least one of the plurality of first support pillars is configured to suction the substrate via the suction passage when the substrate is received from the top ring.

3. The pusher according to claim 1 or 2, wherein
the first elevating mechanism is configured to bring the support surface into contact with the substrate by raising the first base and move the first base down while the substrate is suctioned via the suction passage when the substrate is received from the top ring.

4. The pusher according to claim 3, further comprising
a sensor for detecting presence/absence of a substrate on the support surface, wherein
the first elevating mechanism is configured to repeat moving the first base up and down in a case where the sensor detects that there is no substrate in a state where the first base is moved down when the substrate is received from the top ring.

5. The pusher according to any one of claims 1 to 4, further comprising:
a plurality of second support pillars having one ends and support surfaces for supporting the top ring when the substrate is gripped or released to the top ring and when the substrate is received from the top ring on the one ends;
a second base coupled to other ends of the plurality of second support pillars; and
a second elevating mechanism configured to move the first base and the second base up and down.

6. A substrate transfer apparatus for transferring a substrate, comprising:
a plurality of first transfer rollers configured to support a lower surface of a substrate;
a plurality of first roller shafts to which the plurality of transfer rollers are mounted;
a motor for rotating the plurality of first roller shafts; and
the pusher according to any one of claims 1 to 5 for lifting the substrate on the plurality of first transfer rollers to grip or release the substrate to the top ring and placing the substrate received from the top ring on the plurality of first transfer rollers, wherein
the pusher is arranged such that the plurality of first support pillars pass through clearances between the plurality of first roller shafts.

7. The substrate transfer apparatus according to claim 6, wherein
the pusher is arranged such that the plurality of first support pillars and the plurality of second support pillars pass through the clearances between the plurality of first roller shafts.

8. The substrate transfer apparatus according to claim 6 or 7, further comprising:
a plurality of second transfer rollers configured to support an upper surface of the substrate; and
a plurality of second roller shafts to which the plurality of second transfer rollers are mounted, wherein
the motor is configured to rotate the second roller shaft along with the first roller shaft.

9. The substrate transfer apparatus according to claim 8, further comprising:
a thickness sensor configured to measure a thickness of the substrate; and
a driving device configured to adjust an interval between the plurality of first transfer rollers and the plurality of second transfer rollers by moving at least one position of the plurality of first transfer rollers and the plurality of second transfer rollers corresponding to a measurement result by the thickness sensor.

10. The substrate transfer apparatus according to claim 9, further comprising
an elastic member configured to bias the second transfer roller toward a direction to the first transfer roller.

11. A substrate processing apparatus comprising:
a polishing module for polishing a substrate;
a transfer module for transferring the substrate; and
a drying module for drying the substrate, wherein
the transfer module includes the substrate transfer apparatus according to any one of claims 6 to 10.

12. A substrate processing apparatus comprising:
a top ring configured to hold a back surface of a substrate with a surface to be polished facing downward;
a pusher configured to grip or release the substrate between the pusher and the top ring; and
a wedge mechanism including a wedge member arranged at a side of the substrate held onto the top ring when the substrate is gripped or released from the top ring to the pusher, and a driving member configured to move the wedge member in a direction along the back surface of the substrate to insert the wedge member between the back surface of the substrate and the top ring.

13. The substrate processing apparatus according to claim 12, wherein
the wedge member has a first surface extending parallel to the back surface of the substrate and a second surface opposed to the first surface and inclining to taper off toward a direction to the substrate.

14. The substrate processing apparatus according to claim 13, wherein
the wedge member has a hole internally passing through the wedge member to open to the second surface, and
the wedge mechanism further includes a fluid supply source configured to inject a fluid from the second surface via the hole.

15. The substrate processing apparatus according to any one of claims 12 to 14, wherein
the pusher includes a first stage for gripping or releasing the substrate between the pusher and the top ring, a first elevating mechanism for moving the first stage up and down, and an inclination mechanism for inclining the first stage.

16. The substrate processing apparatus according to claim 15, wherein
the pusher is configured to peel an end of the substrate off of the top ring by inclining the first stage using the inclination mechanism when the substrate is gripped or released from the top ring to the pusher.

17. The substrate processing apparatus according to claim 16, wherein
the pusher is configured to move the first stage down using the first elevating mechanism and horizontalize the first stage using the inclination mechanism after the end of the substrate is peeled off of the top ring.

18. The substrate processing apparatus according to claim 17, wherein
the first elevating mechanism includes a first piston supporting a bottom surface of the first stage and a first cylinder configured to move the first piston up and down, and
the inclination mechanism includes a first rotation shaft provided between the first piston and the first stage, a shaft extending to a side from the first piston, a second rotation shaft mounted on a bottom surface of the first stage, a second piston supporting the first stage via the second rotation shaft, a third rotation shaft mounted on an upper surface of the shaft, and a second cylinder supported by the shaft via the third rotation shaft and configured to move the second piston up and down.

19. The substrate processing apparatus according to any one of claims 15 to 18, wherein
the first stage includes a plurality of first support pillars having one ends and support surfaces for supporting the substrate via a suction pad on the one ends and a first base coupled to other ends of the plurality of first support pillars, and at least one of the plurality of first support pillars include a suction passage communicating with a vacuum source and opening to the support surface.

20. The substrate processing apparatus according to any one of claims 15 to 19, further comprising
a second stage for supporting the top ring when the substrate is gripped or released between the pusher and the top ring and a second elevating mechanism for moving the first stage and the second stage up and down, wherein
the second stage includes a plurality of second support pillars having one ends and support surfaces for supporting the top ring when the substrate is gripped or released between the pusher and the top ring on the one ends and a second base coupled to other ends of the plurality of second support pillars, and
the wedge member is provided in at least one of the plurality of second support pillars.
